# EUROPEAN PATENT APPLICATION

(11) **EP 4 719 038 A1**
(43) Date of publication of application: **01.04.2026**
(21) Application number: 25189959.7
(22) Date of filing: 16.07.2025
(51) Int. Cl.: H10W 76/42, H10W 40/70, H10H 29/20, H10W 76/17, H10W 90/00, H10W 74/40

(54) **NTEGRATED CIRCUIT PACKAGES INCLUDING A HIGH THERMAL CONDUCTIVITY MATERIAL IN 3 DIMENSIONAL DIE STACKS**

(30) Priority: 25.09.2024 US 202418895526
(71) Applicant: Intel Corporation, Santa Clara, CA 95054 (US)
(72) Inventor: Eid, Feras, Chandler, 85226 (US); Li, Wenhao, Chandler, 85286 (US); Vyatskikh, Andrey, Hillsboro, 97123 (US); Brezinski, William, Beaverton, 97008 (US); Vreeland, Richard Farrington, Portland, 97201 (US); Jezewski, Christopher J., Portland, 97229 (US); Sounart, Thomas, Chandler, 85226 (US); Swan, Johanna M., Scottsdale, 85255 (US); Njuki, Michael, Hillsboro, 97123 (US); Elsherbini, Adel A., Chandler, 85248 (US); Dogiamis, Georgios, Chandler, 85226 (US); Naderi, Golsa, Portland, 97229 (US); Talukdar, Tushar, Wilsonville, 97070 (US)
(74) Representative: Goddar, Heinz J.

(57) **Abstract**

Microelectronic assemblies, related devices and methods, are disclosed herein. In some embodiments, a microelectronic assembly may include a first die having a surface; a second die and a third die, the second die and the third die having a first surface and an opposing second surface, wherein the first surfaces of the second die and the third die are electrically coupled to the surface of the first die; a first material on the surface of the first die and around and between the second die and the third die, the first material having a non-planar surface; and a layer on and in physical contact with the non-planar surface of the first material and with the second surfaces of the second die and the third die, the layer including a second material having a thermal conductivity equal to or greater than 10 watt per meter-kelvin (W/m-K).

## Description

### BACKGROUND

Electronic circuits when commonly fabricated on a wafer of semiconductor material, such as silicon, are called ICs. The wafer with such ICs is typically cut into numerous individual dies. The dies may be packaged into an IC package as 3-dimensional (3D) die stacks containing one or more dies along with other electronic components such as resistors, capacitors, and inductors. The IC package may be integrated onto an electronic system, such as a consumer electronic system.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1A is a schematic cross-sectional view of an example microelectronic assembly according to some embodiments of the present disclosure.
FIG. 1B is a schematic cross-sectional view of a portion of the example microelectronic assembly of FIG. 1A.
FIGS. 2A-2D are schematic cross-sectional views of other example microelectronic assemblies according to some embodiments of the present disclosure.
FIGS. 3A-3F are schematic cross-sectional views of different stages of an example process for manufacturing the microelectronic assembly of FIG. 1A according to some embodiments of the present disclosure.
FIGS. 4A-4C are schematic cross-sectional views of other example microelectronic assemblies according to some embodiments of the present disclosure.
FIG. 4D is a schematic cross-sectional view of a portion of the example microelectronic assembly of FIG. 4C.
FIGS. 4E and 4F are schematic cross-sectional views of other example microelectronic assemblies according to some embodiments of the present disclosure.
FIGS. 5A-5D are schematic cross-sectional views of other example microelectronic assemblies according to some embodiments of the present disclosure.
FIGS. 6A-6D are schematic cross-sectional views of other example microelectronic assemblies according to some embodiments of the present disclosure.
FIGS. 7A and 7B are schematic cross-sectional views of yet other example microelectronic assemblies according to some embodiments of the present disclosure.
FIGS. 8A-8C are schematic cross-sectional views of other example microelectronic assemblies according to some embodiments of the present disclosure.
FIG. 8D is a schematic cross-sectional view of a stage in an example process for manufacturing the microelectronic assembly of FIG. 8C according to some embodiments of the present disclosure.
FIG. 9 is a cross-sectional view of a device package that includes one or more microelectronic assemblies in accordance with any of the embodiments disclosed herein.
FIG. 10 is a cross-sectional side view of a device assembly that includes one or more microelectronic assemblies in accordance with any of the embodiments disclosed herein.
FIG. 11 is a block diagram of an example computing device that includes one or more microelectronic assemblies in accordance with any of the embodiments disclosed herein.

### DETAILED DESCRIPTION

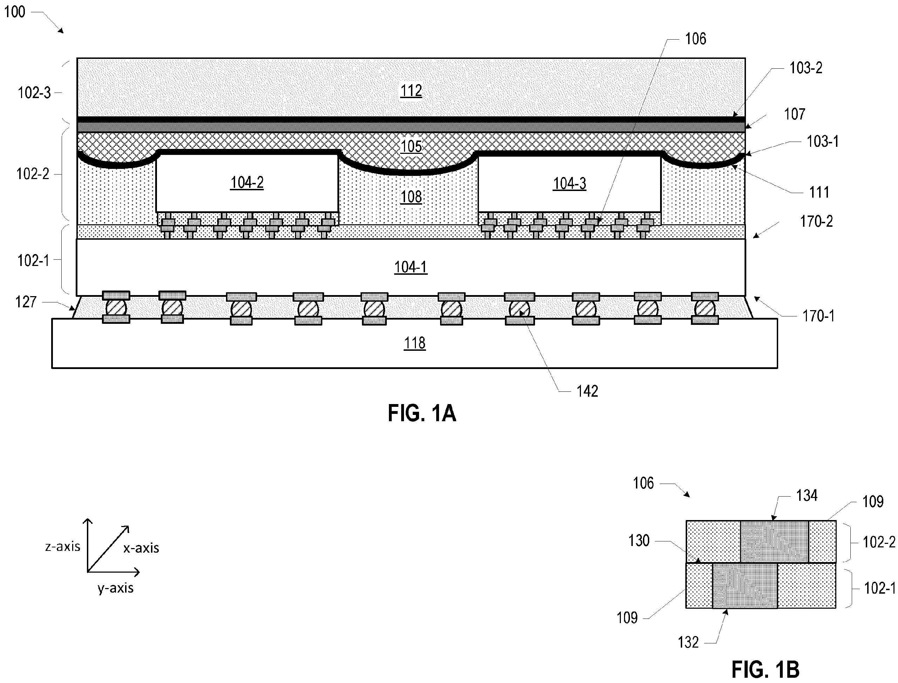

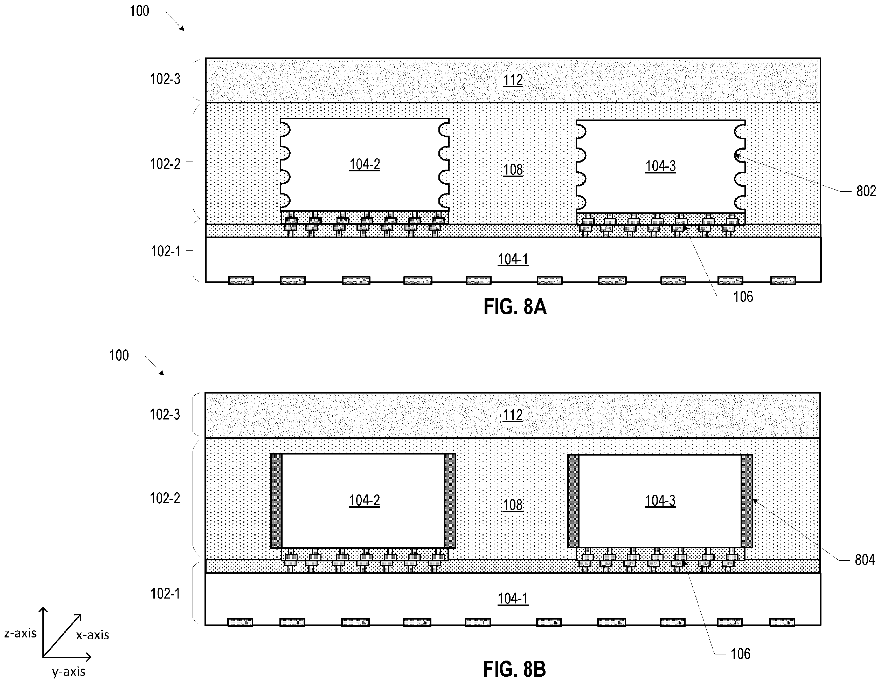

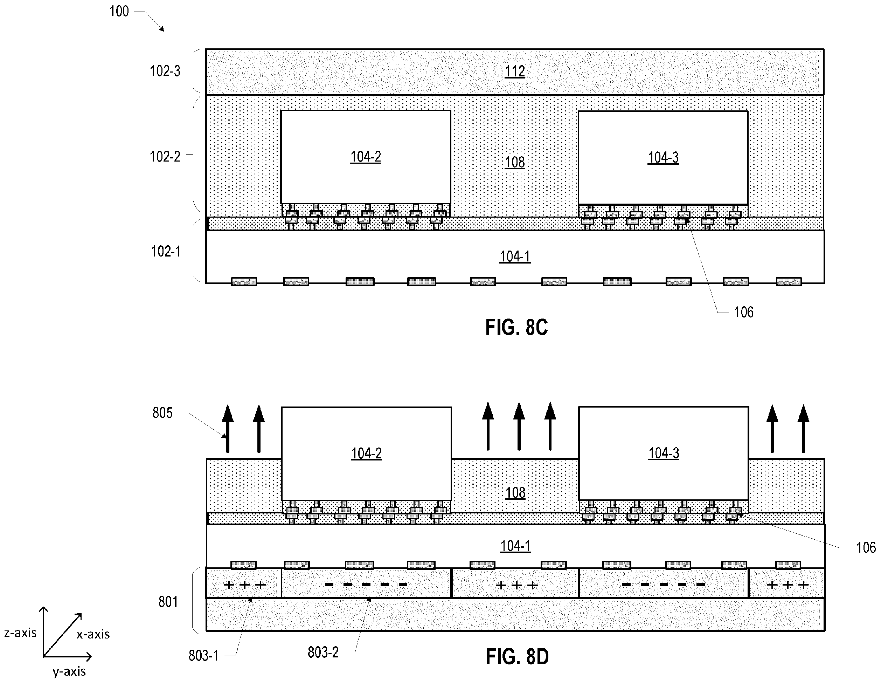

In today's 3D stacked architectures, chiplets, also referred to herein as dies, are often bonded to a base wafer (e.g. monolithic or disaggregated dies) having through-substrate vias (TSVs) and the gaps between the chiplets are then filled with a dielectric material (e.g., silicon oxide); the process is called gap fill. The chiplets are coupled to the base wafer using high-density interconnects also referred to herein as hybrid bonds. As used herein, "high-density interconnects" include die-to-die (DTD) interconnects having a pitch of less than 10 microns. As used herein, pitch is measured center-to-center (e.g., from a center of an interconnect to a center of an adjacent interconnect). The 3D stacked architecture may also be combined to allow for top-packaged chips to communicate with other dies vertically using through-dielectric vias (TDVs), also referred herein as "conductive vias," which are typically larger than TSVs. The deposition of the gap fill material continues to several microns above the tops of the chiplets. Planarization processes such as chemical mechanical polishing (CMP) are then used to remove some of this extra thickness. However, due to the different CMP removal rate of gap fill material versus the adjacent silicon, removing the gap fill material entirely from above the chiplets would leave some topography in the gap fill areas between them (e.g., creates an irregular topography 111, as shown in FIG. 1), which would degrade or prevent subsequent bonding of a structural silicon wafer. As a result, some finite thickness (e.g., usually between 1 micron and 3 microns) of gap fill material is left above the chiplets after planarization (e.g., as shown in FIG. 8) to be used as the bonding layer to the structural silicon. One challenge with this approach is that this bonding layer has a high thermal resistance due to the low thermal conductivity of typical gap fill materials (e.g. silicon oxide has a thermal conductivity of about 1 watt per meter-Kelvin (W/m-K), which is less than 1/100 that of silicon) and reduces heat transfer. Another challenge with this approach is that a gap fill material typically fills vertically and horizontally, and forms an interface seam at an angle between a horizontal surface of the base wafer and a sidewall of the chiplet, which may create additional thermal resistance of the gap fill material. Further, the gap fill material is commonly deposited using a plasma-enhanced chemical vapor deposition (PECVD) process, which, as a result of the aspect ratios involved in the deposition process and the conformal nature of the gap fill material, creates high stresses in the gap fill material on the sidewalls of the chiplets leading to cracks. Once cracks start to form, they tend to propagate through the gap fill material and/or the chiplets, with additional mechanical and/or thermal stresses increasing the severity of crack propagation. In particular, thermal cycling of the IC package during manufacture and operation may encourage crack propagation. Crack formation and propagation compromises the structural integrity of IC packages and makes them particularly prone to failure over time. Crack formation may further lead to void formations between the gap fill material and the structural silicon lid and decrease thermal dissipation.

Embodiments of the present disclosure relate to various techniques, as well as to related devices and methods, for alleviating (e.g., mitigating or reducing) the high thermal resistance of the bond layer and high stresses of the gap fill material. One aspect of the present disclosure includes planarizing the gap fill layer after deposition to completely expose the chiplets, and then depositing a high thermal conductivity (HTC) material (e.g., having a thermal conductivity of equal to or greater than 10 W/m-K) to correct the inconsistent topography of the gap fill material post planarization (e.g., as shown in FIGS. 1A, 2A-2D, and 3A-3F). A thin liner (e.g., diffusion barrier) may be deposited between the gap fill material and the HTC material to prevent diffusion of the HTC material into the chiplets or into the gap fill material. A bonding material layer may be deposited on the HTC material to enable bonding to a structural wafer, which may have its own thin bonding material layer. This approach may reduce the thermal resistance of the gap fill material by more than 10 times, which minimizes the overall thermal resistance to heat removal from the chiplets and enables higher power and increase system performance during operation.

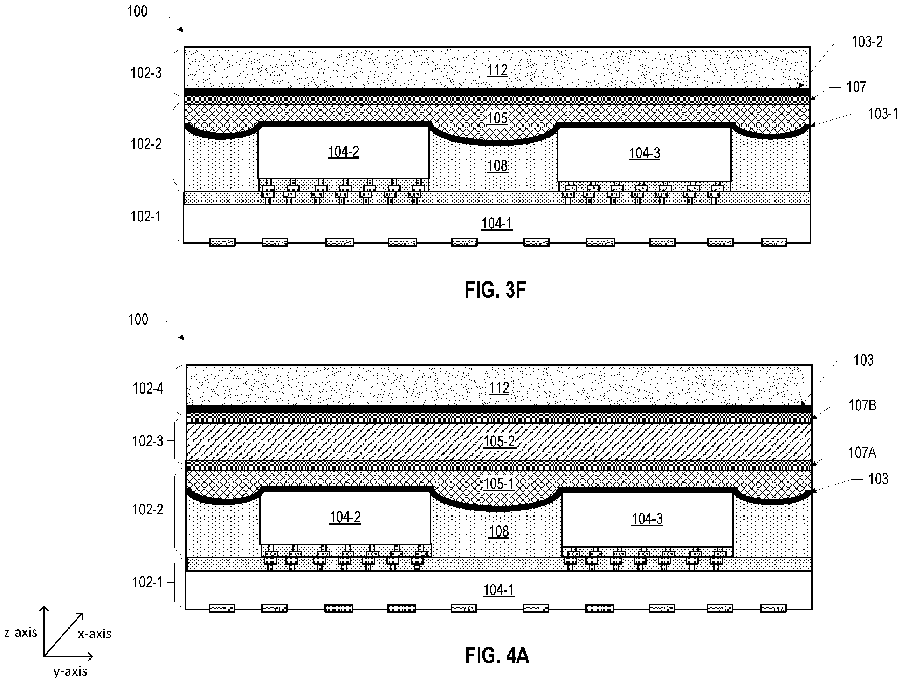

Another aspect of the present disclosure further includes adding an HTC material layer in an IC package with stacked dies (e.g., as shown in FIGS. 4A-4F) that functions as a heat spreader to prevent locally high temperatures, also known as "hot spots," that can exceed temperature limits and degrade package performance. Heat spreaders are currently incorporated into the package lid with a thermal interface material (TIM) applied to contact a backside of a die. This may not be sufficient for 3D heterogeneous integration of disparate chiplets into multi-layer die complexes, where heat spreaders may be needed at different chiplet locations or layers within the stack. A thin bond material layer (e.g., titanium) deposited on an HTC material may allow an HTC material layer of any thickness to be fabricated on a separate substrate and integrated into a 3D die complex, where needed, to function as a heat spreader. Such heat spreader fabrication is not constrained by process limitations of monolithic fabrication on the die in the assembly, such as thermal budgets or film stress, because they can be fabricated ex situ and bonded during assembly. In some such heat spreader embodiments, an HTC material may be a high thermal conductivity material having a thermal conductivity of equal to or greater than 150 W/m-K.

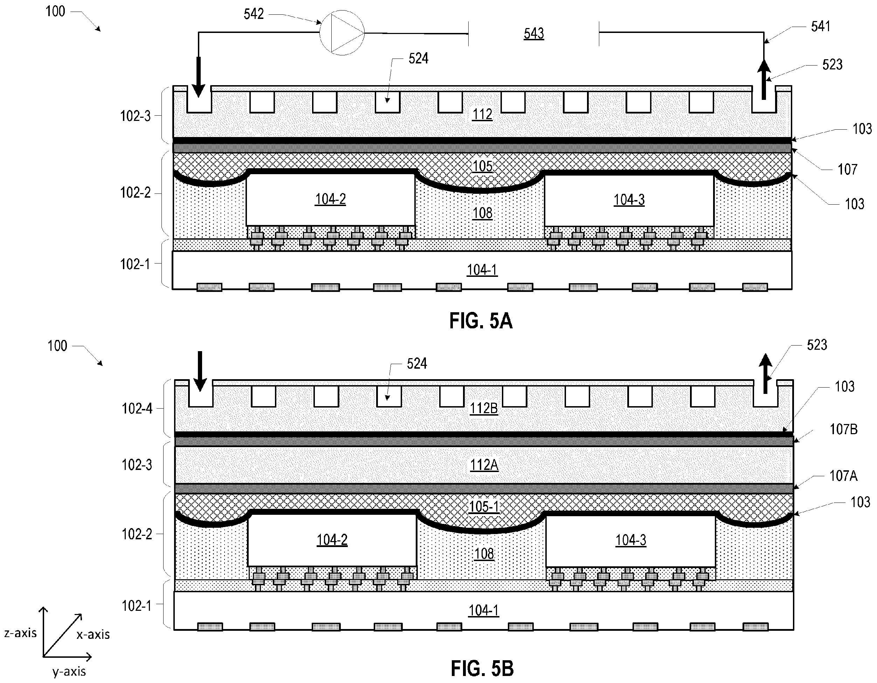

Another aspect of the present disclosure further includes adding a substrate with microchannels for flowing a cooling fluid to an IC package with stacked dies that has an HTC material layer (e.g., as shown in FIGS. 5A-5D). As described above, an IC package having stacked dies may include a substrate (i.e., a structural silicon lid) bonded on top of the chiplets. In this aspect, a substrate includes microchannels with a cooling fluid to form a substrate-based microchannel cooler. Thermal stress at an interface may be lowered by integrating a substrate-based microchannel cooler, for example, as compared to using a metal-based microchannel embedded integrated heat spreader (IHS), as there is no coefficient of thermal expansion (CTE) mismatch between the chiplet and the substrate. Further, a substrate-based microchannel cooler is a thermally superior compared to a convention cold plate (with TIM1 and TIM2) or the microchannel embedded IHS due to the elimination of excessive thermal resistance interfaces (TIMs) from the stack.

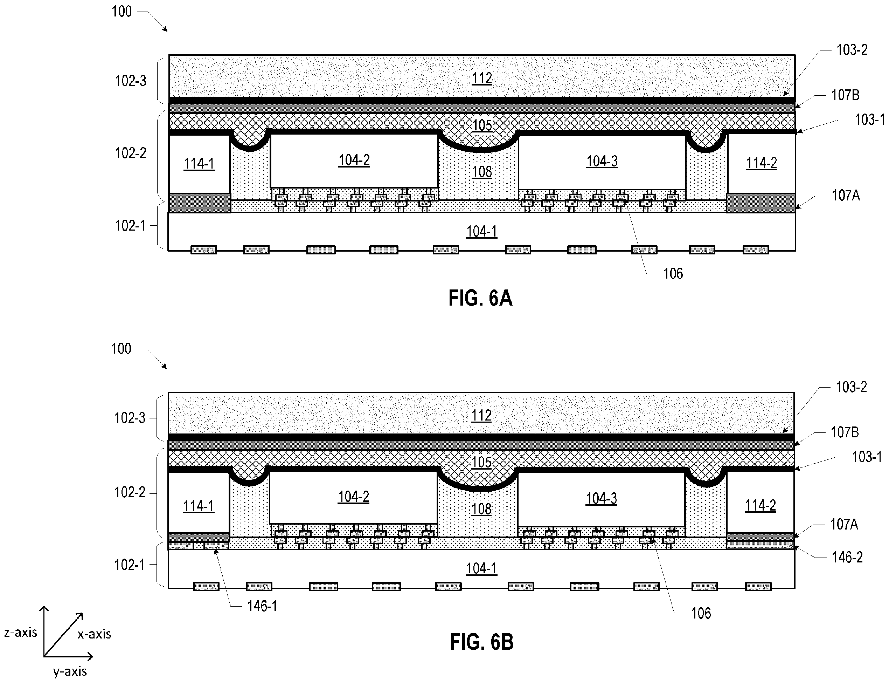

Another aspect of the present disclosure further includes adding dummy dies to an IC package with stacked dies, where the dummy dies are conductively coupled to a base wafer and to an HTC material layer (e.g., as shown in FIGS. 6A-6D). In today's 3D stacked architectures, dummy or non-functional (NF) structural chiplets are often bonded to a base wafer (e.g. monolithic or disaggregated base wafer) to satisfy system thermomechanical requirements. Such dummy dies are usually bonded to the base wafer using a dielectric fusion bond or a metallic-dielectric hybrid bond for better thermal interface resistance and bonded to a structural silicon lid at a top of 3D die complexes using a dielectric bonding layer, such as silicon oxide, silicon nitride, or silicon carbon nitride. The challenge with this approach is that such bonding layers at both surfaces of the dummy dies have a high thermal resistance due to the low thermal conductivity of the dielectric materials typically used for bonding (e.g. silicon oxide has a thermal conductivity of about 1 W/m-K, which is less than 1/100 that of silicon), which creates a thermal bottleneck for heat removal from the base die during operating conditions. Conductively coupling dummy dies on both surfaces may reduce a cost of assembly as no accurate alignment is needed compared to hybrid bonding and may increase thermal dissipation of the base wafer by reducing the interface temperature of coefficient resistance (TCR) (e.g., metal versus dielectric layer). Thermal dissipation may be further improved by utilizing materials that have higher thermal conductivity than silicon, such that the bonding interface does not dominate the total thermal conductivity.

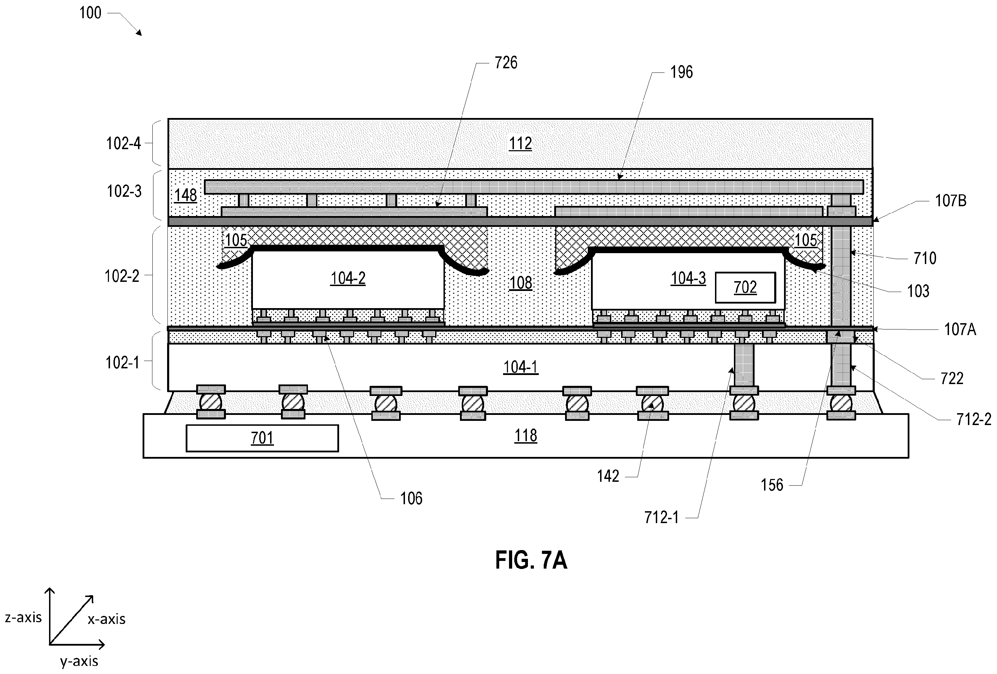

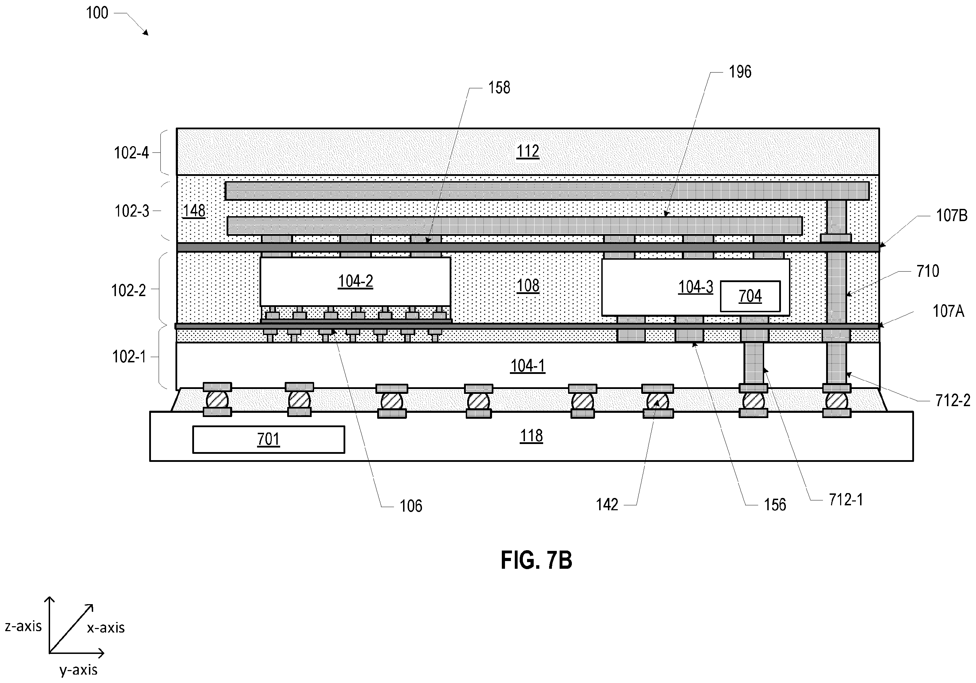

Another aspect of the present disclosure further includes adding dies that include circuitry for power delivery and adding a substrate having a redistribution layer (RDL) to an IC package with stacked dies that has an HTC material layer (e.g., as shown in FIG. 7A) or has a bonding material layer (e.g., as shown in FIG. 7B). As the demand for a faster microchip increases, so does the power demand. Power delivery in IC packages with stacked dies is challenging due to the increase in power densities, which results in less resources to deliver power and limit the performance of such architectures. One of most significant challenges includes addressing die-to-die interfaces. With new technologies, scaling the interface's physical sizes has improved input/output (I/O) capabilities, however, this has not been true for power delivery. Conventional power delivery methods follow the lithography density level hierarchical flow of system where high voltage power comes in through the circuit board, is routed to the package substrate, and is eventually routed to the fine-featured die. Newer methods have been focusing on reducing these paths by vertically integrating the power delivery path by having the voltage regulators either on top or bottom of the dies. Direct metal-to-metal bonding forms better thermal interfaces, while also working as a power delivery path, and has the ease of forming lines and/or planes rather than point contacts. Disclosed herein are power delivery structures that use the thin bonding layer and lines and/or planes in an RDL, or use the HTC material layer, the thin bonding layer, and lines and/or planes in an RDL, as power delivery paths.

Another aspect of the present disclosure includes reducing or eliminating the interface seam between chiplets in an IC package with stacked dies and mitigating stresses in the gap fill material during deposition by increasing sidewall surface area roughness, by depositing a protective coating material, or by using an electrostatic effect during gap fill deposition (e.g., as shown in FIGS. 8A-8C). The increased surface roughness may reduce the adhesion of the gap fill material to the sidewall and result in a more horizontal directional fill during the PECVD process. The protective coating material may include a material that reduces the precursor absorption of the gap fill material to the sidewall during the PECVD process due to its hydrophobicity. The electrostatic effect during deposition may preferentially deposit the gap fill material for a more horizontal directional fill during the PECVD process. With reduced adhesion to the sidewalls, the gap fill material follows a more bottom-up filling, leading to a seamless fill, less cracking, and a void-free bond between the gap fill material and the structural silicon lid.

The different aspects of the present disclosure may be detected when any of the structures described herein are examined using, for example, images of suitable characterization tools such as scanning electron microscopy (SEM) images and transmission electron microscope (TEM) images. The different compositions of the materials of the structures described herein may be detected using, for example, energy-dispersive X-ray spectroscopy (EDS). Surface roughness may be determined using, for example, atomic force microscope (AFM).

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may comprise substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a silicon-on-insulator (SOI) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a non-crystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of I/O functions, arithmetic operations, pipelining of data, etc.).

In another example, the terms "package" and "IC package" are synonymous, as are the terms "die" and "IC die." Note that the terms "chiplet," "chip," "die," and "IC die" are used interchangeably herein.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" or "insulator" (also called herein as "dielectric material" or "dielectric") refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon, silicon oxide, silicon carbide, silicon carbonitride, silicon nitride, and alumina or a combination thereof. They may include dielectric materials, high polarizability materials, and/or piezoelectric materials. A dielectric material may include any suitable dielectric material commonly used in semiconductor manufacture, such as silicon and one or more of oxygen, nitrogen, hydrogen, and carbon (e.g., in the form of silicon oxide, silicon nitride, silicon oxynitride, or silicon carbon nitride); a polyimide material; or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., MOSFETs. In many embodiments, an FET is a four-terminal device. In silicon-on-insulator, or nanoribbon, or gate all-around (GAA) FET, the FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides, including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO₂), borosilicate (e.g., 70-80 wt% SiO₂, 7-13 wt% of B₂O₃, 4-8 wt% Na₂O or K₂O, and 2-8 wt% of Al₂O₃) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, DTD interconnects and die-to-package substrate (DTPS) interconnects. DTD interconnects may also be referred to as first-level interconnects (FLI). DTPS interconnects may also be referred to as Second-Level Interconnects (SLI).

Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects.

In some embodiments, the pitch of the DTD interconnects may be different from the pitch of the DTPS interconnects, although, in other embodiments, these pitches may be substantially the same.

The DTPS interconnects disclosed herein may take any suitable form. In some embodiments, a set of DTPS interconnects may include solder (e.g., solder bumps or balls that are subject to a thermal reflow to form the DTPS interconnects). DTPS interconnects that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of DTPS interconnects may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

The DTD interconnects disclosed herein may take any suitable form. In some embodiments, some or all of the DTD interconnects in a microelectronic assembly or an IC package as described herein may be metal-to-metal interconnects (e.g., copper-to-copper interconnects, or plated interconnects). In such embodiments, the conductive contacts on either side of the DTD interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of a DTD interconnect may include a metal pillar (e.g., a copper pillar), and the other side of the DTD interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, the dies on either side of a set of DTD interconnects may be bare (e.g., unpackaged) dies.

In some embodiments, the DTD interconnects may include solder. For example, the DTD interconnects may include conductive bumps or pillars (e.g., copper bumps or pillars) attached to the respective conductive contacts by solder. In some embodiments, a thin cap of solder may be used in a metal-to-metal interconnect to accommodate planarity, and this solder may become an intermetallic compound during processing. In some embodiments, the solder used in some or all of the DTD interconnects may have a higher melting point than the solder included in some or all of the DTPS interconnects. For example, when the DTD interconnects in an IC package are formed before the DTPS interconnects are formed, solder-based DTD interconnects may use a higher-temperature solder (e.g., with a melting point above 200 degrees Celsius), while the DTPS interconnects may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, a set of DTD interconnects may include an anisotropic conductive material, such as any of the materials discussed above for the DTPS interconnects. In some embodiments, the DTD interconnects may be used as data transfer lanes, while the DTPS interconnects may be used for power and ground lines, among others.

In microelectronic assemblies or IC packages as described herein, some or all of the DTD interconnects may have a finer pitch than the DTPS interconnects. In some embodiments, the DTPS interconnects disclosed herein may have a pitch between about 80 microns and 300 microns, while the DTD interconnects disclosed herein may have a pitch between about 0.5 microns and 100 microns, depending on the type of the DTD interconnects. An example of silicon-level interconnect density is provided by the density of some DTD interconnects. In some embodiments, the DTD interconnects may have too fine a pitch to couple to the package substrate directly (e.g., too fine to serve as DTPS interconnects). The DTD interconnects may have a smaller pitch than the DTPS interconnects due to the greater similarity of materials in the different dies on either side of a set of DTD interconnects than between a die and a package substrate on either side of a set of DTPS interconnects. In particular, the differences in the material composition of dies and package substrates may result in differential expansion and contraction of the die dies and package substrates due to heat generated during operation (as well as the heat applied during various manufacturing operations). To mitigate damage caused by this differential expansion and contraction (e.g., cracking, solder bridging, etc.), the DTPS interconnects in any of the microelectronic assemblies or IC packages as described herein may be formed larger and farther apart than DTD interconnects, which may experience less thermal stress due to the greater material similarity of the pair of dies on either side of the DTD interconnects.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may comprise the same or different insulating materials. In some embodiments, the levels of underfill may comprise thermoset epoxies with silicon oxide particles; in some embodiments, the levels of underfill may comprise any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," "at," "adjacent to," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. For example, a layer of a first solder material may be described as in contact with an underlying layer of a second solder material notwithstanding that there may be one or more layers of other material, such as inter-metallic compounds, formed or appearing at the interface between the two layers of solder material. Another example is an interfacial oxidation or dielectric layer appearing between two metal layers that are in contact, and so forth. Therefore, as used herein, two structures such as two layers of material may still be referred to as being in contact by being over, under, between, at, or adjacent to regardless of the existence of other structures, such as one or more interfacial layers, or other intermediate or intervening layers, between those two layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

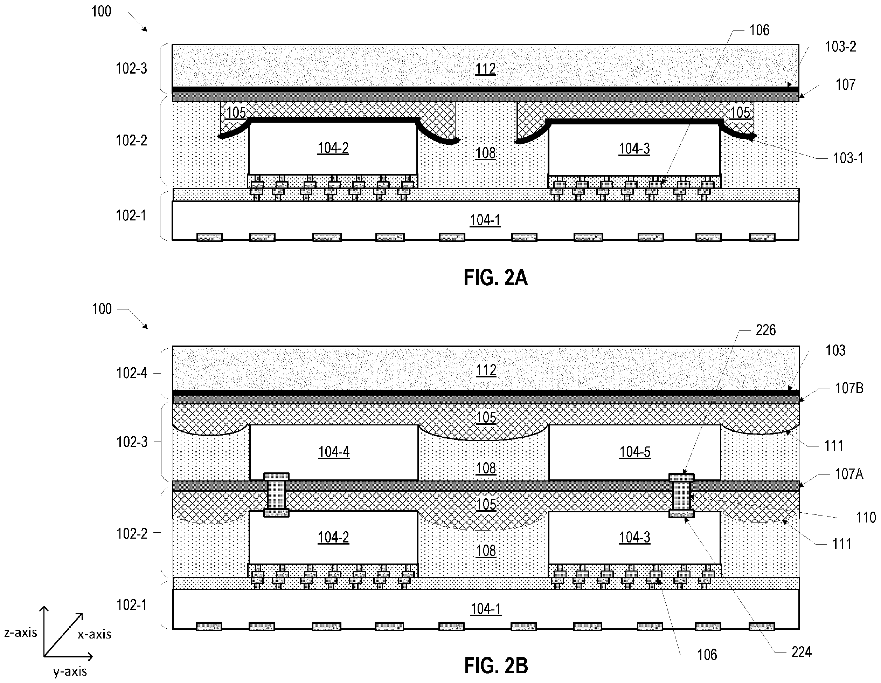

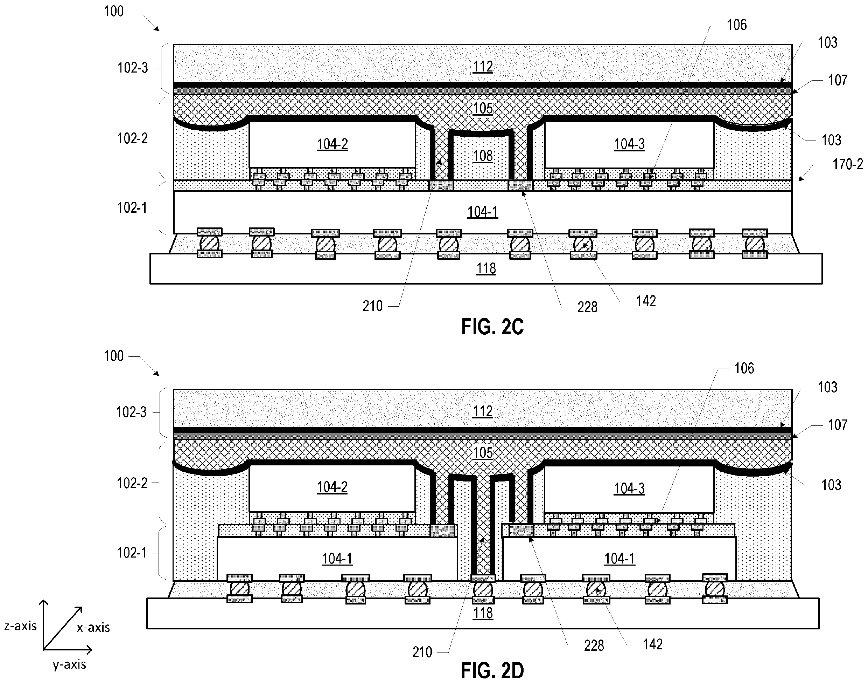

For convenience, if a collection of drawings designated with different letters are present (e.g., FIGS. 2A-2D), such a collection may be referred to herein without the letters (e.g., as "FIG. 2"). Similarly, if a collection of reference numerals designated with different numerals or letters are present (e.g., 104-1, 104-2, 104-3), such a collection may be referred to herein without the numerals or letters (e.g., as "104").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

FIG. 1A is a schematic cross-sectional view of an example microelectronic assembly 100 according to some embodiments of the present disclosure. Microelectronic assembly 100 comprises a plurality of layers 102 (e.g., 102-1, 102-2, and 102-3) and stacked dies 104 (e.g., 104-1, 104-2, 104-3). In particular, a microelectronic assembly 100 includes a first die 104-1 in a first layer 102-1, a second die 104-2 and a third die 104-3 in a second layer 102-2 surrounded by a dielectric material 108, also referred to herein as a "gap fill material," having an inconsistent topography 111 (e.g., non-planar surface) and an HTC material 105 on the dielectric material 108 and on second and third dies 104-2, 104-3, and a substrate 112, also referred to herein as a "structural silicon lid," in a third layer 102-3. The HTC material 105 may form a planar surface for bonding to the substrate 112. The substrate 112 may comprise a structurally stiff and thermally conductive base, such as silicon, that may provide mechanical support and stability to the microelectronic assembly 100.

The HTC material 105 may include any suitable material having a thermal conductivity of equal to or greater than 10 W/m-K, for example, copper, aluminum, aluminum and nitrogen (e.g., in the form of aluminum nitride), diamond, silicon and carbon (e.g., in the form of silicon carbide), boron and nitrogen (e.g., in the form of boron nitride), and boron and arsenic (e.g., in the form of boron arsenide). The HTC material 105 may have any suitable dimensions, for example, a thickness (e.g., z-dimension) of the HTC material 105 on the top surfaces of the second die 104-2 and the third die 104-3 is between 1 micron and 2 microns. The HTC material 105 may have a greater thickness on the dielectric material 108 due to the inconsistent topography 111 where the dielectric material 108 may have one or more divots (e.g., hollows or depressions) with a depth (e.g., z-dimension) of between 20 nanometers and 500 nanometers. The dielectric material 108 may include any suitable material, for example, silicon and nitrogen (e.g., in the form of silicon nitride), silicon and oxygen (e.g., in the form of silicon oxide), or silicon, carbon, and nitrogen (e.g., in the form of silicon carbon nitride); a polymer material (e.g., an epoxy or a polyimide); a mold material; or a low-k or ultra low-k dielectric. The dielectric material 108 may be formed using any suitable process, including chemical vapor deposition (CVD), physical vapor deposition (PVD), lamination, or slit coating and curing.

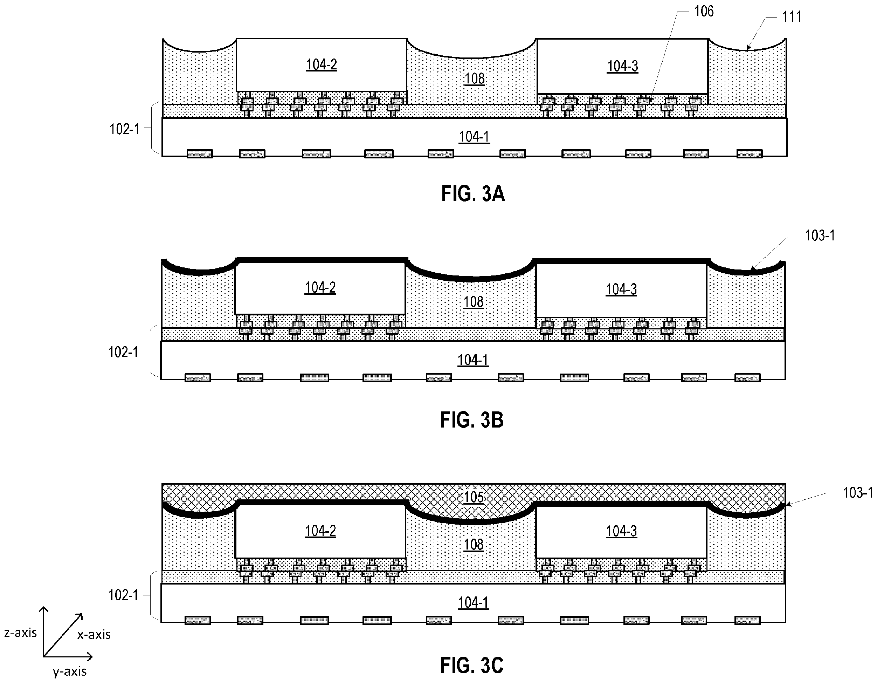

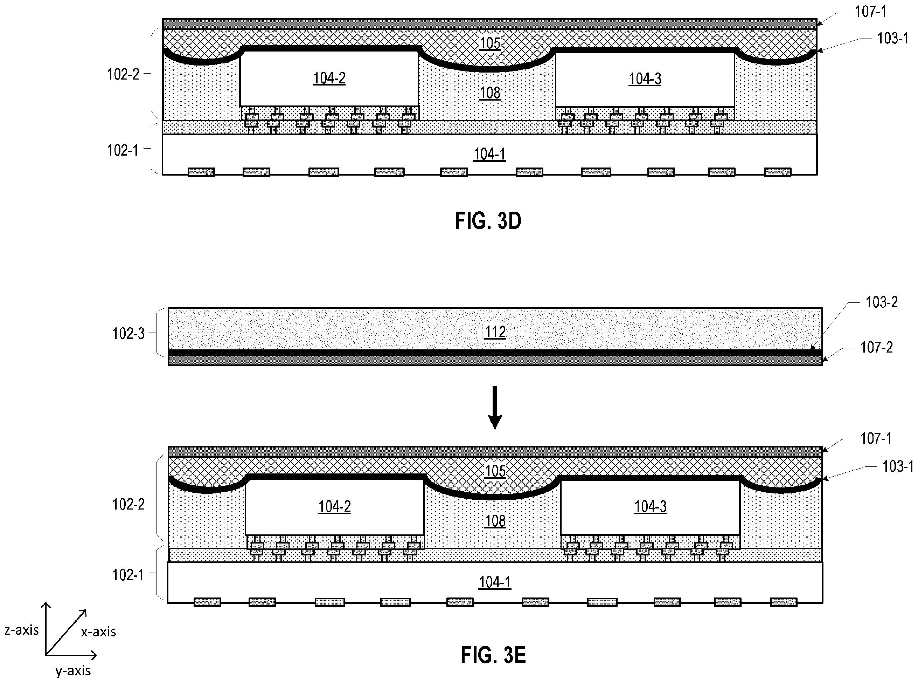

The microelectronic assembly 100 may further include a bonding layer 107 for bonding the substrate 112 of the third layer 102-3 to the HTC material 105 of the second layer 102-2. The bonding layer 107 may include any suitable material, for example, a material of the bonding layer 107 may include one or more of titanium, tantalum, gold, ruthenium, silver, aluminum and nitrogen, silicon and oxygen, silicon and nitrogen, and silicon, carbon, and nitrogen. The bonding layer 107 may have any suitable dimensions, for example, a thickness (e.g., z-dimension) of the bonding layer 107 may be between 0.2 nanometers and 100 nanometers. A bonding material may be deposited on a bonding surface of the substrate 112 and on a bonding surface of the HTC material 105, then bonded together to form the bonding layer 107, as described below with reference to FIG. 3.

The microelectronic assembly 100 may further include a liner 103-1 between the dielectric material 108 and the top surfaces of IC dies 104-2, 104-3, and between the dielectric material 108 and the HTC material 105. The microelectronic assembly may also include a liner 103-2 between the bonding layer 107 and the substrate 112. A liner 103-1 may function as a diffusion barrier to prevent the migration of the HTC material 105 into the dielectric material 108 and into a material of the second and third dies 104-2, 104-3. A liner 103-2 may function as a diffusion barrier to prevent the migration of a material of the bonding layer 107 into a material of the substrate 112. A liner 103 (e.g., liner 103-1, 103-2) may include any suitable material including, for example, one or more of titanium, titanium and nitrogen, tantalum, tantalum and nitrogen, ruthenium, and tungsten. A liner 103 may have any suitable dimensions, for example, a liner 103 may have a thickness between 1 nanometer and 50 nanometers.

The first die 104-1 may include a first surface 170-1 (e.g., a bottom surface) and an opposing second surface 170-2 (e.g., a top surface). The second die 104-2 and the third die 104-3 may be coupled to the second surface 170-2 of the first die 104-1 by interconnects 106. In various embodiments, interconnects 106 may have a pitch of less than 10 microns between adjacent interconnects. An example of interconnect 106 in some embodiments is a hybrid bond, comprising metal-metal and dielectric-dielectric bonds.

FIG. 1B is a schematic cross-sectional view of a detail of a particular one of interconnects 106 in microelectronic assembly 100. Note that although only interconnect 106 is shown, the same structure and description may apply to any other such interconnects comprising hybrid bonds in microelectronic assembly 100 where applicable. In a general sense, interconnect 106 may include, at an interface 130 between layers 102-1 and 102-2, metal-metal bonds between bond-pad 132 of layer 102-1 and bond-pad 134 of layer 102-2, and dielectric-dielectric bonds (e.g., oxide-oxide bonds) in a dielectric material 109 of layers 102-1 and 102-2. Bond-pad 132 of layer 102-1 may bond with bond-pad 134 of layer 102-2. Dielectric material 109 (e.g., silicon oxide, silicon nitride, silicon oxynitride, etc.) in layers 102-1 and 102-2 may bond with each other. In some embodiments, the dielectric material 109 may be a same material as the dielectric material 108. The bonded metal and dielectric materials form interconnect 106, comprising hybrid bonds, providing electrical and mechanical coupling between layers 102-1 and 102-2. In various embodiments, interconnects 106 may have a linear dimension of less than 5 micrometers and a pitch of less than 10 micrometers between adjacent interconnects.

Turning back to FIG. 1A, the die 104 disclosed herein may include an insulating material (e.g., a dielectric material formed in multiple layers, as known in the art) and multiple conductive pathways formed through the insulating material (not shown). In some embodiments, the insulating material of a die 104 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 104 may include a semiconductor material, such as silicon, germanium, or a III-V material (e.g., gallium nitride), and one or more additional materials. For example, an insulating material may include silicon oxide or silicon nitride. The conductive pathways in a die 104 may include conductive traces, conductive vias, and/or TSVs and may connect any of the conductive contacts in the die 104 in any suitable manner (e.g., connecting multiple conductive contacts on a same surface or on different surfaces of the die 104). The conductive pathways in the dies 104 may be bordered by liner materials, such as adhesion liners and/or barrier liners, as suitable. In some embodiments, the first die 104-1 is a wafer. In some embodiments, the die 104 is a monolithic silicon, a fan-out or fan-in package die, or a die stack (e.g., wafer stacked, die stacked, or multi-layer die stacked). In various embodiments, die 104 may include, or be a part of, one or more of a central processing unit (CPU), a memory device (e.g., a high-bandwidth memory device), a logic circuit, input/output circuitry, a transceiver such as a field programmable gate array transceiver, a gate array logic such as a field programmable gate array logic, of a power delivery circuitry, a III-V or a III-N device such as a III-N or III-N amplifier (e.g., GaN amplifier), Peripheral Component Interconnect Express (PCle) circuitry, Double Data Rate (DDR) transfer circuitry, or other electronic components known in the art. In some embodiments, second die 104-2 and third die 104-3 may comprise different functionalities. As used herein, the term "functionality" with reference to a die refers to one or more functions (e.g., capability, task, operation, action, instruction execution, etc.) that the die in question can perform. In other embodiments, second die 104-2 and third die 104-3 may comprise the same or similar functionalities. In some embodiments, first die 104-1 may be configured to carry power, signals and/or ground connection between package substrate 118 and second and third dies 104-2, 104-3. In various embodiments, one or more die 104 in microelectronic assembly 100 may include different kinds of conductive traces, such as conductive traces configured to carry power and conductive traces configured to carry signals, having different dimensions (e.g., conductive traces configured to carry power may, in general, be larger (e.g., thicker, wider) than conductive traces configured to carry signals).

In some embodiments, a microelectronic assembly 100 may include a second die 104-2 and a third die 104-3 with sidewalls having an increased surface roughness and/or scallops 802 or having a protective coating material 804, as described below with reference to FIGS. 8A and 8B.

The microelectronic assembly 100 may also include a package substrate 118 having conductive pathways (not shown) through a dielectric material. The conductive pathways may include conductive traces coupled by conductive vias. The package substrate 118 may further include bond-pads, redistribution layers, substrate cores, passive components and other elements, which are not shown merely for ease of illustration and not as limitations. Package substrate 118 may be coupled to the first surface 170-1 of the first die 104-1 by interconnects 142 (e.g., DTPS interconnects, such as flip-chip solder bonds). In various embodiments, interconnects 142 may have a pitch greater than 10 micrometers between adjacent interconnects. An underfill material 127 may be disposed around interconnects 142. The underfill process may include dispensing underfill material in liquid form, allowing the material to flow and fill interstitial gaps around interconnects 142, and subjecting the assembly to a curing process, such as baking, to solidify the material.

FIG. 2A is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes a patterned HTC material 105 instead of a blanket HTC material 105 (e.g., as shown in FIG. 1A). The patterned HTC material 105 may be on and extended partially beyond the top surfaces of the second die 104-2 and the third die 104-3. The patterned HTC material allows for electrical coupling between components (e.g., as described below with reference to FIG. 7) and for easier singulation. If multiple assemblies are manufactured together and require singulation, singulating between the second and third dies 104-2, 104-3 is more readily performed through the dielectric material 108 without having to cut through the HTC material 105, which is likely to increase stress and possibly cause delamination in the microelectronic assembly. If the microelectronic assembly 100 includes a liner 103-1, the liner 103-1 also may be patterned.

FIG. 2B is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein includes four layers (e.g., 102-1, 102-2, 102-3, 102-4) with a bonding layer 107A between the second and third layers 102-2, 102-3 and a bonding layer 107B between the third and fourth layers 102-3, 102-4. In particular, the third layer 102-3 includes a fourth die 104-4 and a fifth die 104-5 surrounded by a dielectric material 108 having an inconsistent topography 111 (e.g., non-planar surface) and an HTC material 105 on the dielectric material 108 and on the fourth and fifth dies 104-4, 104-5. A conductive contact 224 on a top surface of the second die 104-2 may be electrically coupled to a conductive contact 226 on a bottom surface of the fourth die 104-4 by a conductive via 110, and a conductive contact 224 on a top surface of the third die 104-3 may be electrically coupled to a conductive contact 226 on a bottom surface of the fifth die 104-5 by a conductive via 110. The conductive via 110 may extend through the HTC material 105 and the bonding layer 107A, and, if included in the microelectronic assembly 100, through a liner 103 (not shown). The conductive via 110 may be formed of any suitable conductive material, such as copper, silver, nickel, gold, aluminum, or other metals or alloys, for example. In some embodiments, the conductive via 110 may be bordered by an insulating material, such as an inorganic dielectric containing silicon, oxygen, nitrogen, and/or carbon, that isolates the conductive material of the conductive via 110 from the HTC material 105, the bonding layer 107, and/or the liner 103. The microelectronic assembly 100 may further include a fourth layer 102-4 on the third layer 102-3, and the fourth layer 102-4 including a substrate 112 coupled to the HTC material 105 of the third layer 102-3 by a bonding layer 107. A material of the bonding layer 107A, 107B may include any suitable material, including the materials described above with reference to the bonding layer 107 in FIG. 1A.

FIG. 2C is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes a conductive via 210 through the dielectric material 108. The conductive via 210 may be formed of any suitable conductive material, such as copper, silver, nickel, gold, aluminum, or other metals or alloys, for example, and may be formed of a same material as the HTC material 105. A first end of the conductive via 210 may be electrically coupled to a conductive contact 228 at a second surface 170-2 of the first die 104-1 and an opposing second end of the conductive via 210 may be electrically coupled to the HTC material 105. The conductive via 210 may provide another heat transfer pathway in the microelectronic assembly 100. In some embodiments, the conductive vias 201 have a pitch between 10 microns and 500 microns.

FIG. 2D is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes a plurality of first dies 104-1 in the first layer 102-1 and further includes a conductive via 210 extending through the dielectric material 108 between the package substrate 118 and the HTC material 105. In particular, a first end of the conductive via 210 may be electrically coupled to a package substrate 118 by an interconnect 142 and an opposing second end of the conductive via 210 may be electrically coupled to the HTC material 105.

Any suitable techniques may be used to manufacture the microelectronic assemblies 100 disclosed herein. For example, FIGS. 3A-3F are side, cross-sectional views of various stages in an example process for manufacturing the microelectronic assembly 100 of FIG. 1A, in accordance with various embodiments. Although the operations discussed below with reference to FIGS. 3A-3F (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 3A-3F may be modified in accordance with the present disclosure to fabricate others of microelectronic assembly 100 disclosed herein.

FIG. 3A illustrates an assembly subsequent to electrically coupling second and third dies 104-2, 104-3 to a first die 104-1 by forming interconnects 106, depositing a dielectric material 108 on and around second and third dies 104-2, 104-3, and planarizing a top surface of the assembly to remove dielectric material over the IC dies. Any suitable method may be used to place the second and third dies 104-2, 104-3 for example, automated pick-and-place. The assembly of FIG. 3A may be subjected to appropriate bonding processing to form interconnects 106. For example, the bonding process may include applying a suitable pressure and heating to a suitable temperature (e.g., to moderately high temperatures) for a duration of time. The dielectric material 108 may be deposited using any suitable technique, such as CVD, PVD, or PECVD, among others. The top surface of the assembly may be planarized to remove the dielectric 108 using any suitable technique, such as grinding or etching, and subsequently by chemical mechanical polishing (CMP). The planarizing process may expose the top surfaces of the second and third dies 104-2, 104-3 and may form an inconsistent topography 111 on a top surface of the dielectric material 108. In some embodiments, the inconsistent topography 111 on the top surface of the dielectric material 108 may include a hollow with a depth (e.g., z-dimension), as described above with reference to FIG. 1A. In some embodiments, the first die 104-1 may include a plurality of first dies on a carrier (not shown) and the dielectric material 108 may be deposited on and around the plurality of first dies after the second and third dies 104-2, 104-3 are electrically coupled by interconnects 106 to form a microelectronic assembly similar to FIG. 2D.

FIG. 3B illustrates an assembly subsequent to depositing a liner 103-1 on a top surface of the assembly of FIG. 3A. The liner 103-1 may include any suitable material, as described above with reference to FIG. 1A, and may be formed using any suitable process, including PVD, atomic layer deposition (ALD), or CVD. The liner 103-1 may have any suitable dimensions, as described above with reference to FIG. 1A. In some embodiments, a via opening may be formed through the dielectric material 108 to expose a conductive contact on a surface of the first die 104-1 (e.g., conductive contact 228, as shown in FIG. 2C) before depositing a liner 103-1. The via openings may be formed using any suitable technique, such as laser drilling or etching. The liner 103-1 may be deposited on the dielectric material 108 and in the via opening, and then a conductive material may be deposited in the via opening to form a conductive via (e.g., the conductive via 210, as shown in FIG. 2C and/or FIG. 2D). The conductive material may be deposited using any suitable technique, such as electroplating, PVD, or CVD, and may include any suitable material, as described above with reference to FIG. 1A. In some embodiments, the conductive via 210 may be formed when the HTC material 105 is deposited to fill the via openings and to cover a top surface of the assembly.

FIG. 3C illustrates an assembly subsequent to depositing an HTC material 105 on a top surface of the assembly of FIG. 3B. The HTC material 105 may include any suitable material, as described above with reference to FIG. 1A, and may be formed using any suitable process, including electroplating, PVD, or CVD. The HTC material 105 may be deposited to have a greater thickness (e.g., a thickness between 2 microns and 5 microns) and may be planarized to a thickness of between 1 micron and 2 microns above the top surfaces of the second and third dies 104-2, 104-3. The HTC material 105 may be removed using any suitable technique, such as grinding and/or CMP. A liner 103 and an HTC material 105 may be deposited to fully cover the top surface of the assembly (e.g., blanket deposit) and then selectively removed to form a pattern (e.g., as shown in FIG. 2A) using any suitable technique, such as etching.

FIG. 3D illustrates an assembly subsequent to forming a bonding layer 107-1 on a top surface of the assembly of FIG. 3C. The bonding layer 107-1 may be deposited using any suitable technique, such as electroplating, PVD, or CVD, and may include any suitable material, as described above with reference to FIG. 1A. A bonding layer 107-1 may be deposited to have any suitable dimensions, including, for example, a thickness between 0.1 nanometers and 50 nanometers. In some embodiments, for example, when manufacturing a microelectronic assembly 100 of FIG. 2B, via openings may be formed through the bonding layer 107-1, the HTC material 105, and the liner 103, if included, to expose a conductive contact 224 on a top surface of the second and the third dies 104-2, 104-3, an insulating material may be deposited in the via openings, and, subsequently, a conductive material may be deposited in the via openings to form conductive vias 110. A fourth and fifth die 104-4, 104-5 may be attached to the bonding layer 107-1 and a conductive contacts 226 on a bottom surface of the fourth and fifth die 104-4, 104-5 may be electrically coupled to the conductive via 110. A dielectric material 108 may be deposited on and around the fourth and fifth dies 104-4, 104-5 and planarized as described above in FIG. 3A with reference to the dielectric material 108 around the second and third dies 104-2, 104-3.

FIG. 3E illustrates an assembly subsequent to forming a bonding layer 107-2 on a substrate 112 and aligning the bonding layer 107-2 of the substrate 112 with the bonding layer 107-1 of the assembly of FIG. 3D. The bonding layer 107-2 may be deposited using any suitable technique, such as electroplating, PVD, CVD, ALD, or ion beam deposition (IBD), and may include any suitable material, as described above with reference to FIG. 1A. A substrate 112 may include any suitable material for providing mechanical stability during manufacturing operations and use, and in some embodiments, may include silicon. A bonding layer 107-2 may be deposited to have any suitable dimensions, including, for example, a thickness between 0.1 nanometers and 50 nanometers. In some embodiments, a liner 103-2 may be deposited on the substrate 112 prior to depositing the bonding layer 107-2. The liner 103-2 may be deposited using any suitable technique, including as described above with reference to FIG. 3B, and may include any suitable material, as described above with reference to FIG. 1A.

FIG. 3F illustrates an assembly subsequent to attaching the substrate 112 to the HTC material 105 by coupling the bonding layer 107-1 and the bonding layer 107-2 together to form the bonding layer 107. The bonding layers 107-1, 107-2 may be bonded together using any suitable technique, such as by heating, atmospheric bonding, surface-activated bonding, diffusion bonding, or by thermo-compression bonding. If multiple assemblies are manufactured together, the assemblies may be singulated. The assembly of FIG. 3F may itself be a microelectronic assembly 100, as shown. Further manufacturing operations may be performed on the microelectronic assembly 100 of FIG. 3F to form other microelectronic assembly 100; for example, a solder may be applied to conductive contacts at a bottom surface of the first die 104-1 and used to couple the microelectronic assembly 100 of FIG. 3F to a package substrate 118 by interconnects 142, similar to the microelectronic assembly 100 of FIG. 1A.

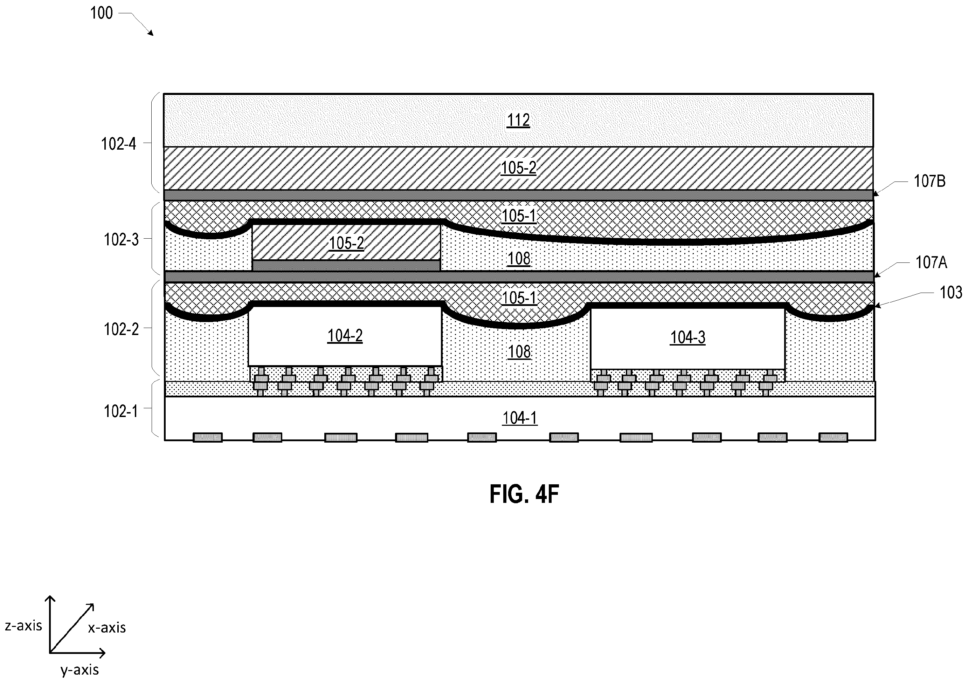

FIG. 4A is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein includes four layers (e.g., 102-1, 102-2, 102-3, 102-4) with a bonding layer 107A between the second and third layers 102-2, 102-3 and a bonding layer 107B between the third and fourth layers 102-3, 102-4. In particular, the third layer 102-3 includes a second HTC material 105-2 that may function as a heat spreader. A second HTC material 105-2 of the third layer 102-3 may be bonded to a first HTC material 105-1 of the second layer 102-2 by a bonding layer 107A. The first HTC material 105-1 may include any suitable material and may have any suitable dimensions, as described above with reference to the HTC material 105 of FIG. 1A. The second HTC material 105-2 may include any suitable material and may have any suitable dimensions. In some embodiments, a second HTC material 105-2 may include any suitable material having a thermal conductivity of equal to or greater than 150 W/m-K, for example, copper, aluminum, aluminum and nitrogen (e.g., in the form of aluminum nitride), diamond, silicon and carbon (e.g., in the form of silicon carbide), boron and nitrogen (e.g., in the form of boron nitride), boron and arsenic (e.g., in the form of boron arsenide), silver, or gold, and may have a thickness (e.g., z-dimension) between 1 micron and 200 microns. In some embodiments, a second HTC material 105-2 may be a single-crystal layer that is epitaxially grown on a carrier, such as a silicon wafer, and subsequently attached to the first HTC material 105-1 by the bonding layer 107A. In some such embodiments, the second HTC material 105-2 may be deposited on a silicon wafer using any high deposition temperature technique, such as PECVD or low pressure chemical vapor deposition (LPCVD), at a temperature range between 500 degrees Celsius and 1000 degrees Celsius, and epitaxially grown to have a crystalline structure that matches the 111-crystalline structure of the silicon material of the wafer. The microelectronic assembly 100 may further include a fourth layer 102-4 on the third layer 102-3, and the fourth layer 102-4 may include a substrate 112 coupled to the second HTC material 105-2 of the third layer 102-3 by a bonding layer 107B. A material of the bonding layer 107A, 107B may include any suitable material, including the materials described above with reference to the bonding layer 107 in FIG. 1A. In some embodiments, for example, when the second HTC material 105-2 is epitaxially grown on a silicon substrate 112, a bonding layer 107B and a liner 103 between the second HTC material 105-2 and the substrate 112 may be omitted (e.g., as shown in FIG. 4F).

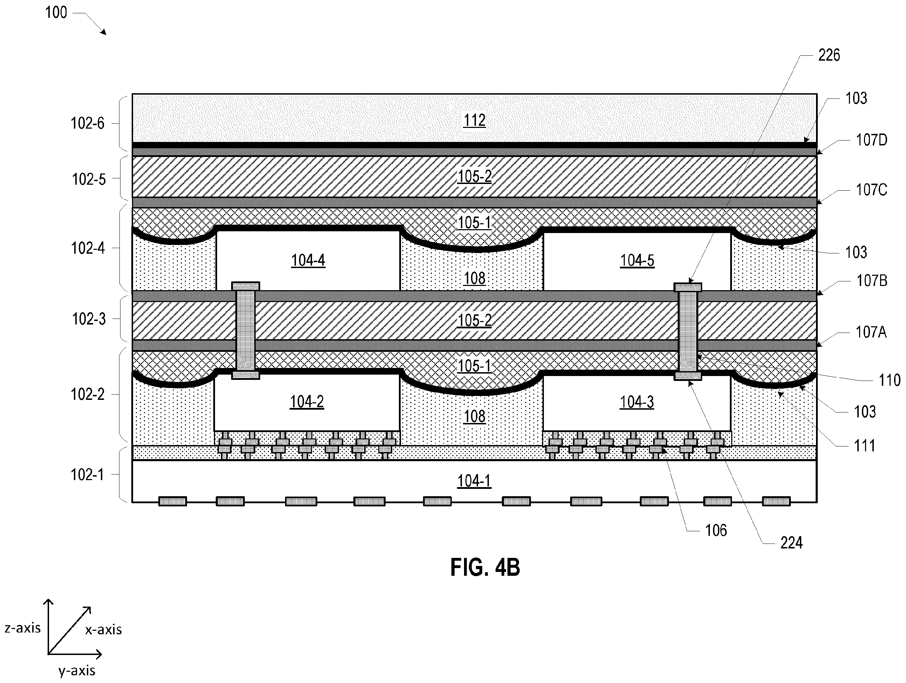

FIG. 4B is a schematic cross-sectional view of another example microelectronic assembly according to some embodiments of the present disclosure. The configuration of the embodiment shown in the figure is like that of FIG. 2B, except for differences as described further. The configuration of microelectronic assembly 100 as described herein includes six layers (e.g., 102-1, 102-2, 102-3, 102-4, 102-5, 102-6) with a bonding layer 107A between the second and third layers 102-2, 102-3, a bonding layer 107B between the third and fourth layers 102-3, 102-4, a bonding layer 107C between the fourth and fifth layers 102-4, 102-5, and a bonding layer 107D between the fifth and sixth layers 102-5, 102-6. In particular, the fourth layer 102-4 includes fourth and fifth dies 104-4, 104-5 surrounded by a dielectric material 108 having an inconsistent topography 111, a liner 103 and a first HTC material 105-1, and the third layer 102-3 and the fifth layer 102-5 include a second HTC material 105-2 that may function as a heat spreader. A conductive contact 224 on a top surface of the second die 104-2 may be electrically coupled to a conductive contact 226 on a bottom surface of the fourth die 104-4 by a conductive via 110, and a conductive contact 224 on a top surface of the third die 104-3 may be electrically coupled to a conductive contact 226 on a bottom surface of the fifth die 104-5 by a conductive via 110. The conductive via 110 may extend through the first HTC material 105-1, the bonding layer 107A, the second HTC material 105-2, and the bonding layer 107B. The conductive via 110 may be formed of any suitable conductive material, such as copper, silver, nickel, gold, aluminum, or other metals or alloys, for example. The conductive via 110 may be bordered by an insulating material to isolate the conductive via 110 from the liner 103, the first and second HTC materials 105-1, 105-2, and the bonding layers 107A, 107B. The insulating material may include any suitable material, for example, as described above with reference to FIG. 2B. The microelectronic assembly 100 may further include a sixth layer 102-6 on the fifth layer 102-5, and the sixth layer 102-6 may include a substrate 112 coupled to the second HTC material 105-2 of the fifth layer 102-5 by a bonding layer 107D. A material of the bonding layer 107A, 107B, 107C, 107D may include any suitable material, including the materials described above with reference to the bonding layer 107 in FIG. 1A.

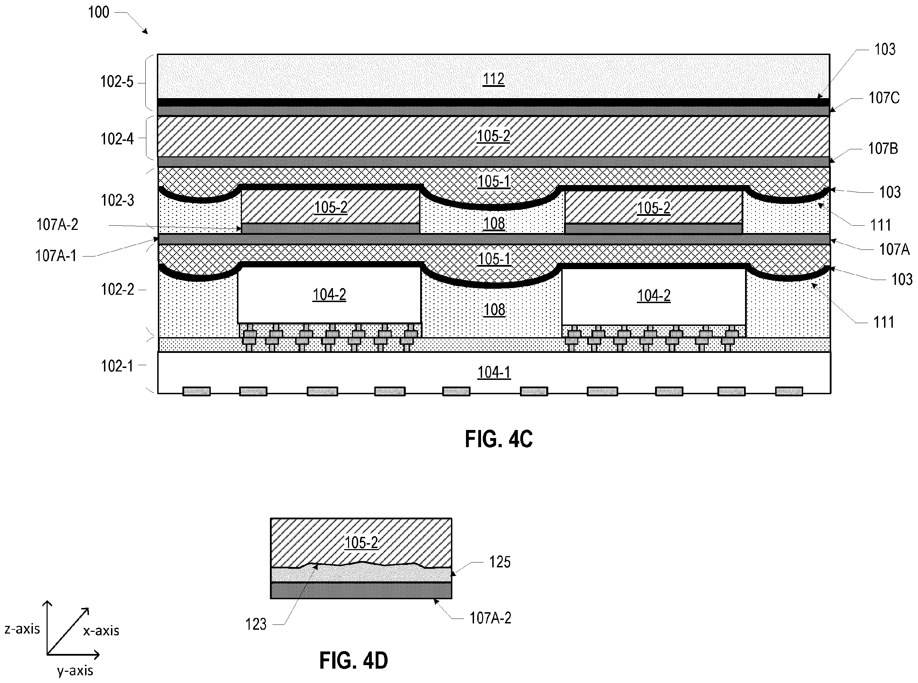

FIG. 4C is a schematic cross-sectional view of another example microelectronic assembly according to some embodiments of the present disclosure. The configuration of the embodiment shown in the figure is like that of FIG. 4A, except for differences as described further. The configuration of microelectronic assembly 100 as described herein includes five layers (e.g., 102-1, 102-2, 102-3, 102-4, 102-5) with a bonding layer 107A between the second and third layers 102-2, 102-3, a bonding layer 107B between the third and fourth layers 102-3, 102-4, and a bonding layer 107C between the fourth and fifth layers 102-4, 102-5. In particular, the second layer 102-2 includes second dies 104-2, and the third layer 102-3 includes a patterned second HTC material 105-2 over the second dies 104-2 and bonded to the first HTC material 105-1 in the second layer 102-2 by the bonding layer 107A. The bonding layer 107A may include a first bonding layer 107A-1 on a top surface of the first HTC material 105-1 and a second bonding layer 107A-2 on the bottom surface of the second HTC material 105-2 that are bonded together. The patterned second HTC material 105-2 may be surrounded by a dielectric material 108 having an inconsistent topography 111. The third layer 102-3 may further include a first HTC material 105-1 on a liner 103, if included, and on the first dielectric material 108. A fourth layer 102-4 including a second HTC material 105-2 may be bonded to the first HTC material 105-1 of the third layer 102-3 by a bonding layer 107B. The patterned second HTC material 105-2 in the third layer 102-3 and the second HTC material 105-2 in the fourth layer may function as heat spreaders. The patterned HTC material 105-2 may function to transfer heat from the second dies 104-2 in the second layer 102-2, the second dies 104-2 may be high-powered dies that produce high levels of heat. The second HTC material 105-2 may be patterned using any suitable technique, including as described above with reference to FIG. 3C. In some embodiments, the second HTC material 105-2 may be reconstituted and patterned on a carrier and subsequently attached to the second layer 102-2 by bonding layer 107A. The second HTC material 105-2 may be attached to the carrier and released for bonding by an infrared (IR) debond film. The microelectronic assembly 100 may further include a fourth layer 102-4 having a second HTC material 105-2 bonded to the first HTC material 105-1 of the third layer 102-3 by a bonding layer 107B and a fifth layer 102-5 having a substrate 112 bonded to the second HTC material 105-2 of the fourth layer 102-4 by a bonding layer 107C. A material of the bonding layer 107A, 107B, 107C may include any suitable material, including the materials described above with reference to the bonding layer 107 in FIG. 1A.

FIG. 4D includes a magnified portion of the patterned second HTC material 105-2 in the third layer 102-3 showing a second HTC material 105-2 having a surface roughness 123 that is greater than or equal to 5 nanometers (e.g., between 5 nanometers and 150 nanometers) and a planarizing material 125 between the second HTC material 105-2 and the bonding layer 107A. The planarizing material 125 may include any suitable material, such as copper or aluminum, that planarizes a surface of the second HTC material 105-2 for forming the bonding layer 107A-2 on the bottom surface of the second HTC material 105-2.

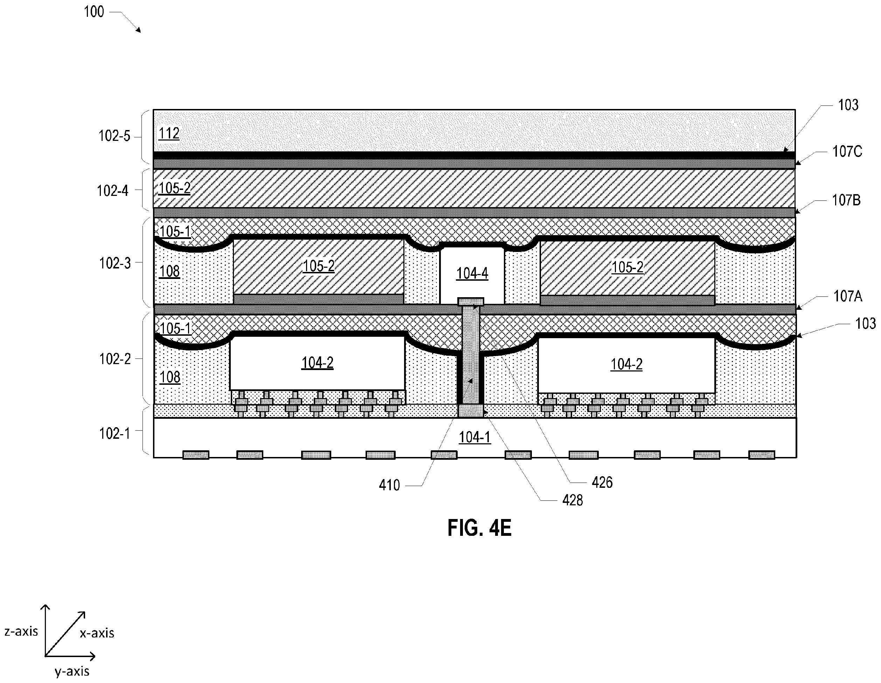

FIG. 4E is a schematic cross-sectional view of another example microelectronic assembly according to some embodiments of the present disclosure. The configuration of the embodiment shown in the figure is like that of FIG. 4C, except for differences as described further. The configuration of microelectronic assembly 100 as described herein includes five layers (e.g., 102-1, 102-2, 102-3, 102-4, 102-5) with a bonding layer 107A between the second and third layers 102-2, 102-3, a bonding layer 107B between the third and fourth layers 102-3, 102-4, and a bonding layer 107C between the fourth and fifth layers 102-4, 102-5. In particular, the third layer 102-3 further includes a fourth die 104-4 adjacent to the patterned second HTC material 105-2 surrounded by the dielectric material 108 and electrically coupled to the first die 104-1 by a conductive via 410. The conductive via 410 may extend through the dielectric material 108 and the first HTC material 105-1 of the second layer 102-2, and the bonding layer 107A and may electrically couple to a conductive contact 426 on a bottom surface of the fourth die 104-4 and to a conductive contact 428 on a top surface of the first die 104-1. The conductive via 410 may be formed of any suitable conductive material, such as copper, silver, nickel, gold, aluminum, or other metals or alloys, for example. The conductive via 410 may be bordered by an insulating material to isolate the conductive via 410 from the liner 103, the first HTC material 105-1, and the bonding layer 107A. The insulating material may include any suitable material, for example, as described above with reference to FIG. 2B.

FIG. 4F is a schematic cross-sectional view of another example microelectronic assembly according to some embodiments of the present disclosure. The configuration of the embodiment shown in the figure is like that of FIG. 4C, except for differences as described further. The configuration of microelectronic assembly 100 as described herein includes four layers (e.g., 102-1, 102-2, 102-3, 102-4) with a bonding layer 107A between the second and third layers 102-2, 102-3, and a bonding layer 107B between the third and fourth layers 102-3, 102-4. In particular, the second layer 102-2 may include a second die 104-2 that is a high heat producing die and a third die 104-3 that is a low heat producing die, and the third layer 102-3 may include a second HTC material 105-2 patterned over the second die 104-2 and not patterned over the third die 104-3. The second HTC material 105-2 may function as a heat spreader to transfer heat generated by the second die 104-2. The fourth layer 102-4 may include a substrate 112 and a second HTC material 105-2 grown epitaxially on the substrate 112 (e.g., as described above with reference to FIG. 4A) and subsequently attached to the third layer 102-3 by bonding layer 107B.

FIG. 5A is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes microchannels 524 through the substrate 112 for transferring heat away from the second die 104-2 and the third die 104-3 in the second layer 102-2. The microelectronic assembly 100 may further include a system that circulates a fluid, also referred to herein as "a cooling fluid," through the microchannels 524. The microchannels 524 may include an input and an output 523 for circulating the fluid. The fluid may be circulated through fluid pathways 541 using a pump or a fan 542, which may be a separate piece of equipment (e.g., as shown) or may be part of a cooling device 543. The microelectronic assembly 100 may further include pipes or connections to a heat exchanger, a chiller, or other device for cooling the fluid (not shown) before returning the fluid to microchannels 524 of the substrate 112. The fluid may be any suitable liquid, gas, or a liquid/gas mixture, such as a coolant (e.g., water, fluorochemical liquids, silicone oil, ethylene glycol water, poly-alpha-olefin, or silicate ester), or the vapor of the liquid coolant, including water and fluorocarbon, that may be circulated, usually by a pump, to dissipate heat more efficiently from the second and/or third dies 104-2, 104-3. The fluid may also include additives to prevent corrosion of the different components or to allow operation at higher/lower temperatures (e.g., additives to water to decrease its freezing point or increase its boiling point). The coolant used may depend on the coolant's properties, including viscosity and heat capacity, circulation flow rate, and the temperature rise during device operation. In some embodiments, the fluid may be an electronic coolant liquid or a dielectric fluid that is electrically insulating, highly thermally stable, non-toxic, chemically inert, non-corrosive with high thermal conductivity. A dielectric fluid may include a dielectric material in a liquid state. For example, the fluid may be an ultra-low-viscosity dielectric heat transfer fluid that includes synthetic hydrocarbon oils. In some embodiments, the fluid may not include sulfur. In some embodiments, the fluid may include a transformer oil, perfluoroalkanes, and purified water.

FIG. 5B is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein includes four layers (e.g., 102-1, 102-2, 102-3, 102-4) with a bonding layer 107A between the second and third layers 102-2, 102-3 and a bonding layer 107B between the third and fourth layers 102-3, 102-4. In particular, the fourth layer 102-4 includes a second substrate 112B having microchannels 524 for transferring heat away from the second die 104-2 and the third die 104-3 in the second layer 102-2 that is bonded to a first substrate 112A in the third layer by a bonding layer 107B. The substrate 112 with microchannels 524 may further include any of the elements described above with reference to FIG. 5A.

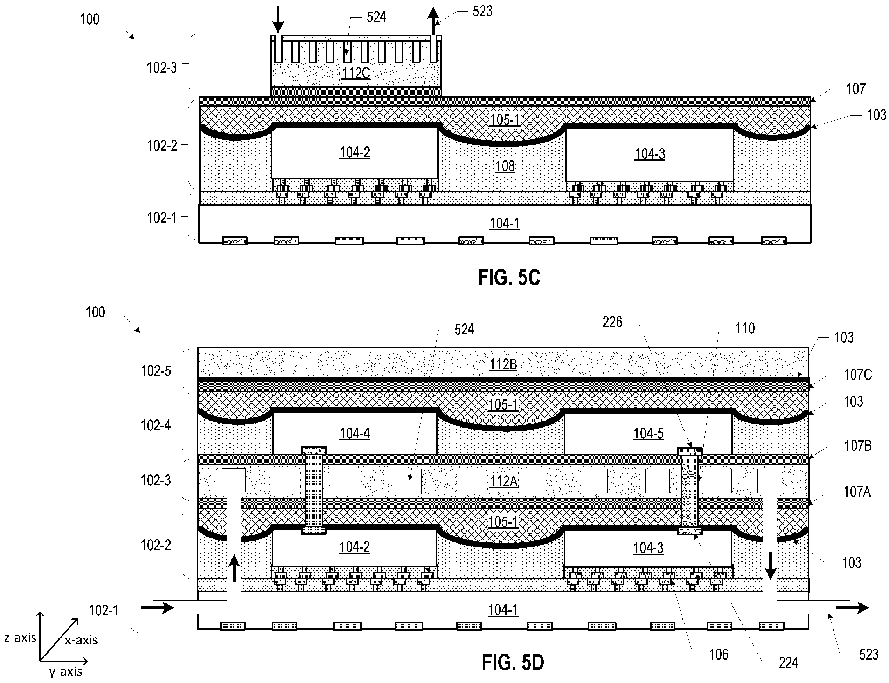

FIG. 5C is a schematic cross-sectional view of another example microelectronic assembly according to some embodiments of the present disclosure. The configuration of the embodiment shown in the figure is like that of FIG. 5A, except for differences as described further. The configuration of microelectronic assembly 100 as described herein includes three layers (e.g., 102-1, 102-2, 102-3) with a bonding layer 107 between the second and third layers 102-2, 102-3. In particular, the third layer 102-3 includes a substrate 112C having microchannels 524 over only the second die 104-2 for transferring heat away from the second die 104-2. The substrate 112C with microchannels 524 may further include any of the elements described above with reference to FIG. 5A.

FIG. 5D is a schematic cross-sectional view of another example microelectronic assembly according to some embodiments of the present disclosure. The configuration of the embodiment shown in the figure is like that of FIG. 2B, except for differences as described further. The configuration of microelectronic assembly 100 as described herein includes five layers (e.g., 102-1, 102-2, 102-3, 102-4, 102-5) with a bonding layer 107A between the second and third layers 102-2, 102-3, a bonding layer 107B between the third and fourth layers 102-3, 102-4, and a bonding layer 107C between the fourth and fifth layers 102-4, 102-5. In particular, the third layer 102-3 includes a substrate 112A having microchannels 524 for transferring heat away from the second die 104-2 and the third die 104-3. The substrate 112B with microchannels 524 may further include any of the elements described above with reference to FIG. 5A. In some embodiments, the substrate 112A with microchannels 524 may include an input and an output 523 that extends at least partially through the first die 104-1 to a lateral surface, as shown. In some embodiments, an input and an output 523 may extend through the first die 104-1 to a bottom surface (not shown). A conductive contact 224 on a top surface of the second die 104-2 may be electrically coupled to a conductive contact 226 on a bottom surface of the fourth die 104-4 by a conductive via 110, and a conductive contact 224 on a top surface of the third die 104-3 may be electrically coupled to a conductive contact 226 on a bottom surface of the fifth die 104-5 by a conductive via 110. The conductive via 110 may extend through the liner 103, if included, and the HTC material 105 in the second layer 102-2, the bonding layer 107A, the first substrate 112A, and the bonding layer 107B. The conductive via 110 may be formed of any suitable conductive material, such as copper, silver, nickel, gold, aluminum, or other metals or alloys, for example. The conductive via 110 may be bordered by an insulating material, such as described above with reference to FIG. 2B, that isolates the conductive material of the conductive via 110 from the HTC material 105, the bonding layer 107A, 107B, and the first substrate 112A. The microelectronic assembly 100 may further include a fifth layer 102-5 on the fourth layer 102-4, and the fifth layer 102-5 may include a substrate 112B coupled to the HTC material 105 of the fourth layer 102-4 by a bonding layer 107C. A material of the bonding layer 107A, 107B, 107C may include any suitable material, including the materials described above with reference to the bonding layer 107 in FIG. 1A.

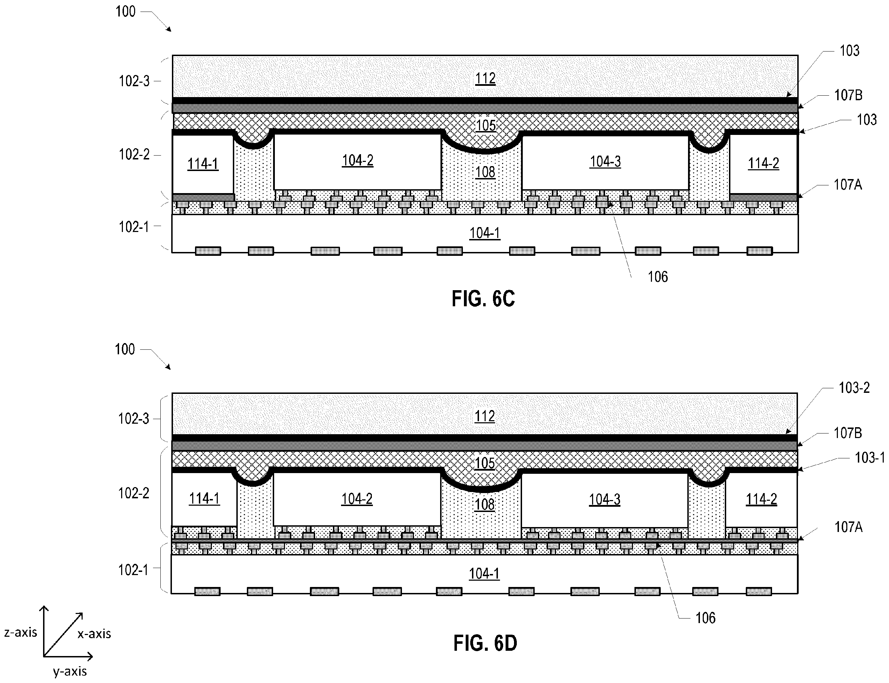

FIG. 6A is a schematic cross-sectional view of another example microelectronic assembly according to some embodiments of the present disclosure. The configuration of the embodiment shown in the figure is like that of FIG. 1A, except for differences as described further. The configuration of microelectronic assembly 100 as described herein further includes dummy dies 114-1, 114-2 in the second layer 102-2 adjacent to the second and third dies 104-2, 104-3. In particular, a bottom surface of the dummy dies 114-1, 114-2 may be conductively coupled to the first die 104-1 by bonding layer 107A and a top surface of the dummy dies 114-1, 114-2 may be conductively coupled to the HTC material 105 and the liner 103, if included. As used herein, the term "dummy die," "dummy silicon," or "non-functional die" refers to a structure that is similar in size and shape to a die but that, unlike a die, does not have active integrated circuitry. For a non-limiting example, a dummy die may have some features found on a die such as bond pads (e.g., to form interconnects 106, as shown in FIG. 6D) but does not contain transistor circuitry that are capable of being powered on or of processing signals. A dummy die 114 may include any suitable structurally stiff, bulk material that may provide mechanical support and stability to a microelectronic assembly 100. The dummy die 114 may include a thermally conductive material, such as silicon, silicon and carbon (e.g., in the form of silicon carbide), gallium and nitrogen (e.g., in the form of gallium nitride), boron and nitrogen (e.g., in the form of hexagonal boron nitride), or diamond, that may enhance heat transfer in a microelectronic assembly 100. As shown in FIG. 6A, the dummy die 114 may be conductively coupled to the first die 104-1 by metal-metal bonds across the interface, for example, using a bonding layer 107. The bonding layer 107 may be formed by coupling a bonding layer on a top surface of the first die 104-1 (e.g., similar to the bonding layer 107-1 in FIG. 3E) and a bonding layer on a bottom surface of the dummy dies 114-1, 114-2 (e.g., similar to the bonding layer 107-2 in FIG. 3E). In some embodiments, the dummy die 114 may include a wafer of silicon cut to fit adjacent to the second and third dies 104-2, 104-3 along an edge or a perimeter of the first die 104-1. The dummy die 114 may have any suitable dimensions. In some embodiments, the dummy die 114 and the second and third dies 104-2, 104-3 may have a same overall thickness (e.g., z-dimension 193). In some embodiments, a dummy die 114 may have a surface area (e.g., xy-dimension) of between 1 millimeter by 1 millimeter and 26 millimeters by 33 millimeters.

FIG. 6B is a schematic cross-sectional view of another example microelectronic assembly according to some embodiments of the present disclosure. The configuration of the embodiment shown in the figure is like that of FIG. 6A, except for differences as described further. The configuration of microelectronic assembly 100 as described herein includes dummy dies 114-1, 114-2 conductively coupled to the first die 104-1 by bonding layer 107A on a bottom surface of the dummy dies 114-1, 114-2 to conductive contacts 146 on a top surface of the first die 104-1. In particular, conductive contacts 146 on a top surface of the first die 104-1 may have different densities. For example, conductive contacts 146-1 may have a prescribed pitch and may cover a surface area that is substantially the same as a surface area of the dummy die 114-1 with spaces between individual conductive contacts 146-1. For example, in some embodiments, conductive contacts 146-1 may have a pitch between 10 microns and 500 microns. Conductive contacts 146-1 may provide increased thermal connectivity, which may allow for improved thermal transfer from the first die 104-1 through the dummy die 114-1 to the HTC material 105. Conductive contact 146-2 may include a blanket conductive material having a surface area (e.g., xy-dimension) that is substantially the same as a surface area of the dummy die 114-2. The conductive contact 146-2 may provide optimal thermal connectivity, which may allow for improved thermal transfer from the first die 104-1 through the dummy die 114-2 to the HTC material 105. Further, conductive contact 146-2 does not require precise alignment during attachment of the dummy die 114-2 to the first die 104-1. A material of the conductive contact 146 may include any suitable conductive material, such as copper, silver, nickel, gold, aluminum, or other metals or alloys, for example.

FIG. 6C is a schematic cross-sectional view of another example microelectronic assembly according to some embodiments of the present disclosure. The configuration of the embodiment shown in the figure is like that of FIG. 6B, except for differences as described further. The configuration of microelectronic assembly 100 as described herein includes dummy dies 114-1, 114-2 conductively coupled to the first die 104-1 by bonding layer 107A on a bottom surface of the dummy dies 114-1, 114-2 to a hybrid bonding region on a top surface of the first die 104-1. As shown in FIG. 1B, the hybrid bonding region may include bond-pads 132 in a dielectric material 109. The bonding layer 107A on the bottom surface of the dummy dies 114-1, 114-2 may conductively couple to the bond-pads 132 in the hybrid bonding region on the top surface of the first die 104-1. The configuration shown in the figure may allow for more thermal connectivity and does not require precise alignment during attachment.

FIG. 6D is a schematic cross-sectional view of another example microelectronic assembly according to some embodiments of the present disclosure. The configuration of the embodiment shown in the figure is like that of FIG. 6C, except for differences as described further. The configuration of microelectronic assembly 100 as described herein includes the second die 104-2, the third die 104-3, and the dummy dies 114-1, 114-2 hybrid bonded to the first die 104-1 with a bonding layer 107A in between the hybrid bonding regions under the dummy dies 114-1, 114-2. In particular, a bonding layer (e.g., similar to the bonding layer 107-2 in FIG. 3E) on a hybrid bonding region at a bottom surface of the second die 104-2, the third die 104-3, and the dummy dies 114-1, 114-2 may be conductively coupled to a bonding layer (e.g., similar to the bonding layer 107-1 in FIG. 3E) on a hybrid bonding region at a top surface of the first die 104-1 to form bonding layer 107A. As shown in FIG. 1B, the hybrid bonding region of the first die 104-1 may include bond-pads 132 in a dielectric material 109 and the hybrid bonding region of the second die 104-2, the third die 104-3, and the dummy dies 114-1, 114-2 may include bond-pads 134 in a dielectric material 109. The bonding layer 107A may assist with bonding, where when in contact with a conductive material, the bonding layer 107A behaves as a conductor, and when in contact with an insulating material, the bonding layer 107A behaves as an insulator. The configuration shown in the figure may allow for more thermal connectivity and does not require precise alignment during attachment.

FIG. 7A is a schematic cross-sectional view of another example microelectronic assembly according to some embodiments of the present disclosure. The configuration of the embodiment shown in the figure is like that of FIG. 2A, except for differences as described further. The configuration of microelectronic assembly 100 as described herein includes four layers (e.g., 102-1, 102-2, 102-3, 102-4) with a bonding layer 107A between the first and second layers 102-1, 102-2 and a bonding layer 107B between the second and third layers 102-2, 102-3. The configuration of the embodiment shown in the figure may be part of a topside power delivery network (PDN), where the package substrate 118 includes a power source 701, the third die 104-3 includes voltage regulator (VR) circuitry 702, the second layer 102-2 includes a conductive via 710 (e.g., also referred to herein as a "TDV") through the dielectric material 108, and the third layer 102-3 includes a redistribution layer (RDL) 148 having conductive contacts 726 at a bottom surface and a conductive pathway 196 through a dielectric. The conductive pathway 196 in the RDL 148 may include one or more conductive lines and/or conductive planes for power delivery. In some embodiments, the RDL 148 may include an array of conductive lines and/or planes where some of the conductive lines and/or planes are coupled to a positive power supply voltage (e.g., also referred to herein as "Vcc") and some of the conductive lines and/or planes are coupled to a ground or zero voltage connection point (e.g., also referred to herein as "Vss"). In some embodiments, an array of conductive lines and/or planes may include alternating rows of Vcc and Vss connections. The conductive pathways 196 may further include conductive vias, as shown. The RDL 148 may be formed on the substrate 112 and subsequently attached to the third layer 102-3 by the bonding layer 107B. The RDL may be formed using any suitable technique, such as a semi-additive process.

A first die 104-1 may further include a conductive via 712 (e.g., also referred herein as a "TSV"). In particular, the first die 104-1 may include a first TSV 712-1 electrically coupled to the third die by interconnects 106 and a second TSV 712-2 electrically coupled to the TDV 710 by an interconnect 156. The interconnect 156 may be one of a plurality of interconnects having a pitch between 10 microns and 100 microns. The interconnects 106, 156 may include the bonding layer 107A. The bonding layer 107A may be formed by coupling a bonding layer (e.g., similar to the bonding layer 107-1 in FIG. 3E) on the hybrid bonding layer and the conductive contact 722 at the top surface of the first die 104-1 and a bonding layer (e.g., similar to the bonding layer 107-2 in FIG. 3E) on the hybrid bonding layer at the bottom surface of the second die 104-2 and the third die 104-3. A material of the TSV 712, the TDV 710, the conductive contacts 722, 726, and the conductive pathway 196 may include any suitable conductive material, such as copper, silver, nickel, gold, aluminum, or other metals or alloys, for example.

The configuration of the embodiment shown in the figure may provide for co-stacked power delivery components and power consuming die. In some embodiments, the second die 104-2 is a power consuming die. In such an embodiment, power may be directly delivered from a power source through the first TSV 712-1 to the third die 104-3 having VR circuitry 702 to the conductive planes (e.g., conductive pathways 196) in the RDL 148 to the second die 104-2. In another such example embodiment, power may be directly delivered from a power source through the second TSV 712-2 and the TDV 710 to the conductive planes (e.g., conductive pathways 196) in the RDL 148 to the second die 104-2. In yet another such example embodiment, power may be directly delivered from a power source (not shown) attached to the conductive planes (e.g., conductive pathways 196) in the RDL 148 to the second die 104-2. In some embodiments, the first die 104-1 is a power consuming die. In such an embodiment, power may be directly delivered from a power source through the second TSV 712-2 and the TDV 710 to the conductive planes (e.g., conductive pathways 196) in the RDL 148 to the third die 104-3 having the VR circuitry 702 to the first die 104-1. The bonding layers 107A, 107B may provide for improved power delivery through the PDN due to lower electrical resistance and increased thermal interface.

FIG. 7B is a schematic cross-sectional view of another example microelectronic assembly according to some embodiments of the present disclosure. The configuration of the embodiment shown in the figure is like that of FIG. 7A, except for differences as described further. The configuration of microelectronic assembly 100 as described herein may include a dielectric material 108 surrounding the second die 104-2 and the third die 104-3, and may not include an HTC material 105 or a liner 103. The microelectronic assembly 100 may further include a third die having passive components 704, such as capacitors (e.g., deep trench or metal-insulator-metal (MIM) capacitors) and/or inductors, which may have non-electrical, conductive interconnects for thermal conducting. The conductive pathway 196 in the RDL 148 may be electrically coupled to the second die 104-2, the third die 104-3, and the TDV 710 by interconnects 158, and the interconnects 158 may include the bonding layer 107B. The interconnects 158 may have a pitch between 10 microns and 100 microns. The third die 104-3 may be electrically coupled to the first die 104-1 by interconnects 156, and the interconnects 156 may include the bonding layer 107A.

FIGS. 8A-8C are schematic cross-sectional views of other example microelectronic assemblies according to some embodiments of the present disclosure. FIG. 8A is a schematic cross-sectional view of an example microelectronic assembly 100 according to some embodiments of the present disclosure. Microelectronic assembly 100 comprises three layers 102 (e.g., 102-1, 102-2, 102-3). In particular, a microelectronic assembly 100 includes a first die 104-1 in a first layer 102-1, a second die 104-2 and a third die 104-3 in a second layer 102-2 surrounded by a dielectric material 108, where sidewalls of the second die 104-2 and the third die 104-3 have an increased surface roughness and/or are scalloped 802, and a substrate 112 in a third layer 102-3. As used herein, the term "scalloped" refers to having an edge or side marked with semicircles. In some embodiments, a dimension of an individual scallop (e.g., y-dimension) is between 10 nanometers and 500 nanometers. The increased surface roughness and/or scalloped 802 sidewalls of the second die 104-2 and the third die 104-3 may be formed using any suitable technique, such as by changing a frequency of the gas switching during a plasma dicing process that includes cyclic isotropic etching followed by a protective film deposition. The increased surface roughness and/or scalloped 802 sidewalls may reduce adhesion of the dielectric material 108 to the sidewalls of the second and third dies 104-2, 104-3 during deposition resulting in a more horizontal directional fill and eliminating an interface seam in the dielectric material 108.

FIG. 8B is a schematic cross-sectional view of another example microelectronic assembly according to some embodiments of the present disclosure. The configuration of the embodiment shown in the figure is like that of FIG. 8A, except for differences as described further. In the configuration of the embodiment shown in the figure, the sidewalls of the second die 104-2 and the third die 104-3 may include a protective coating material 804 and may not have an increased surface roughness and/or scallops. The protective coating material 804 may reduce the precursor adhesion to the sidewalls during deposition of the dielectric material 108 due to its hydrophobicity. With reduced nucleation sites on the sidewalls, during deposition, the dielectric material 108 may have a more horizontal directional fill and an interface seam in the dielectric material 108 may be eliminated. The protective coating material 804 may have any suitable dimensions, for example, the protective coating material 804 may have a width (e.g., y-dimension) between 1 nanometer and 5 nanometers. The protective coating material 804 may include any suitable material, such as a self-assembled monolayer (SAM) material including alkyl and fluoroalkyl silanes (e.g., octadecylsilane (ODS) and perfluorodecyltrichlorosilane (FDTS)), a thiol (e.g., hexadecane thiol), a phosphonic acid (e.g., octadecyl and perfluorooctane phosphonic acid), an alkanoic acid (e.g., heptadecanoic acid), or a non-SAM thin polymer film including a siloxane (e.g., polydimethylsiloxane (PDMS) and derivatives, and hexamethyldisiloxane (HMDSO)), a silazane (e.g., hexamethyldisilazane (HMDS)), a polyolefin (e.g., polypropylene (PP)), or a fluorinated polymer (e.g., polytetrafluoroethylene (PTFE), perfluoropolyether (PFPE), perfluorodecanoic acid (PFDA), or perfluorocyclobutane (C₄F₈) (e.g., as a plasma-deposited polymerized film). The protective coating material 804 may be selectively deposited on the sidewalls or may be deposited on all surfaces and subsequently removed from the top surfaces of the first die 104-1, the second die 104-2, and the third die 104-3.

FIG. 8C is a schematic cross-sectional view of another example microelectronic assembly according to some embodiments of the present disclosure. The configuration of the embodiment shown in the figure is like that of FIG. 8B, except for differences as described further. The configuration of the embodiment shown may not include a protective coating material on the sidewalls of the second die 104-2 and the third die 104-3. The configuration of the embodiment shown further may not include an interface seam in the dielectric material 108. The microelectronic assembly 100 in FIG. 8C may be manufactured using an electrostatic effect to preferentially deposit a dielectric material 108 in a horizontal directional fill and eliminate an interface seam in the dielectric material 108.

FIG. 8D is a schematic cross-sectional view of a stage in an example process for manufacturing the microelectronic assembly of FIG. 8C according to some embodiments of the present disclosure. As shown in FIG. 8D, a first die 104-1 may be placed on an electrostatic chuck 801 having positive zones 803-1 and negative zones 803-2 that attract and repel, respectively, or vice versa, the deposition of the dielectric material 108 in the respective zones. In such embodiments, the dielectric material 108 may be deposited using a PECVD process. The electrostatic chuck 801 may create an electrostatic effect to preferentially deposit a dielectric material 108 in a bottom-up fill 805 utilizing a preferred horizontal deposition component and eliminate an interface seam in the dielectric material 108.

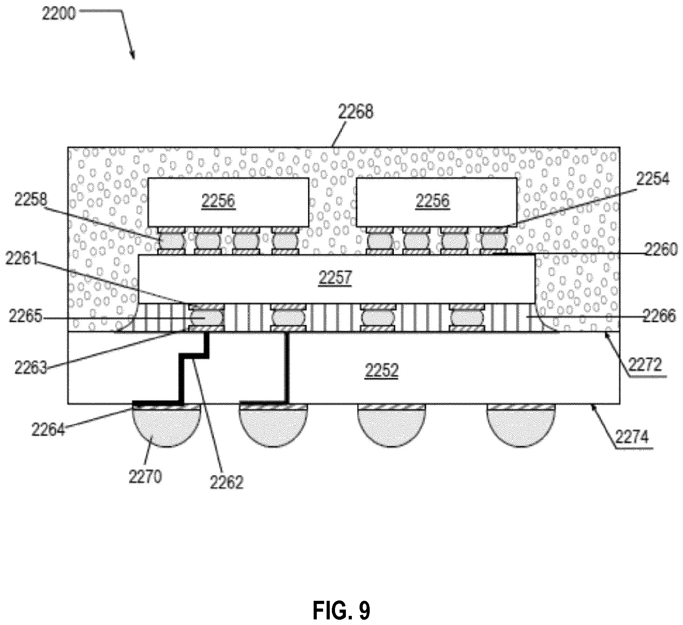

The packages disclosed herein, e.g., any of the microelectronic assemblies 100 or any further embodiments described herein, may be included in any suitable electronic component. FIGS. 9-11 illustrate various examples of packages, assemblies, and devices that may be used with or include any of the IC packages as disclosed herein.

FIG. 9 is a side, cross-sectional view of an example IC package 2200 that may include IC packages in accordance with any of the embodiments disclosed herein. In some embodiments, the IC package 2200 may be a SiP.

As shown in the figure, package substrate 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures comprising lines and/or vias.

Package substrate 2252 may include conductive contacts 2263 that are coupled to conductive pathway 2262 through package substrate 2252, allowing circuitry within dies 2256 and/or interposer 2257 to electrically couple to various ones of conductive contacts 2264 (or to other devices included in package substrate 2252, not shown).

IC package 2200 may include interposer 2257 coupled to package substrate 2252 via conductive contacts 2261 of interposer 2257, first-level interconnects 2265, and conductive contacts 2263 of package substrate 2252. First-level interconnects 2265 illustrated in the figure are solder bumps, but any suitable first-level interconnects 2265 may be used, such as solder bumps, solder posts, or bond wires.

IC package 2200 may include one or more dies 2256 coupled to interposer 2257 via conductive contacts 2254 of dies 2256, first-level interconnects 2258, and conductive contacts 2260 of interposer 2257. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). First-level interconnects 2258 illustrated in the figure are solder bumps, but any suitable first-level interconnects 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

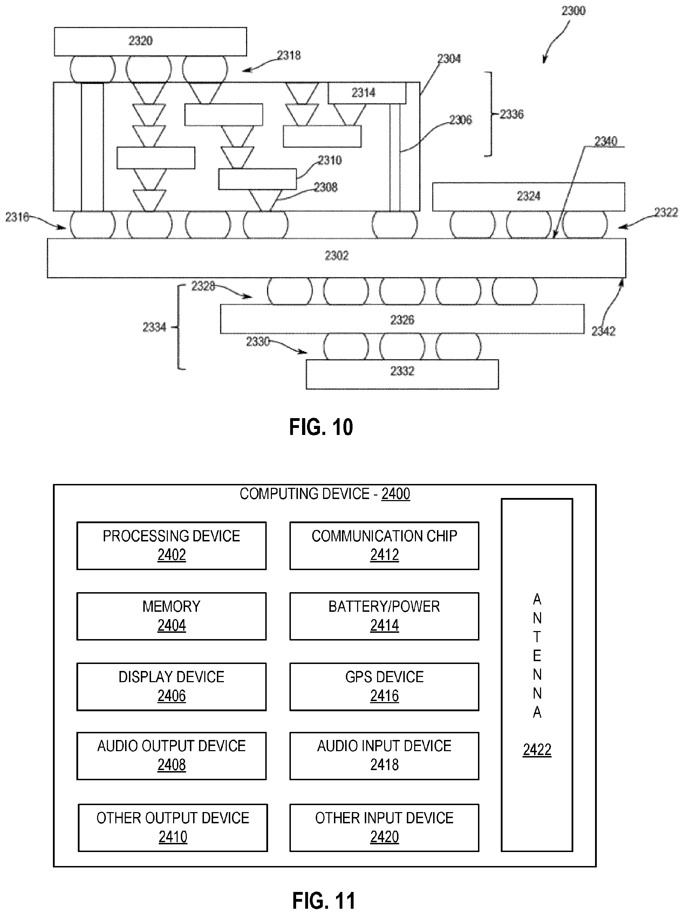

In some embodiments, underfill material 2266 may be disposed between package substrate 2252 and interposer 2257 around first-level interconnects 2265, and mold 2268 may be disposed around dies 2256 and interposer 2257 and in contact with package substrate 2252. In some embodiments, underfill material 2266 may be the same as mold 2268. Example materials that may be used for underfill material 2266 and mold 2268 are epoxies as suitable. Second-level interconnects 2270 may be coupled to conductive contacts 2264. Second-level interconnects 2270 illustrated in the figure are solder balls (e.g., for a ball grid array (BGA) arrangement), but any suitable second-level interconnects 2270 may be used (e.g., pins in a pin grid array arrangement or lands in a land grid array arrangement). Second-level interconnects 2270 may be used to couple IC package 2200 to another component, such as a circuit board (e.g., a motherboard), an interposer, or another IC package, as known in the art and as discussed below with reference to FIG. 10.

In various embodiments, any of dies 2256 may be microelectronic assembly 100 as described herein. In embodiments in which IC package 2200 includes multiple dies 2256, IC package 2200 may be referred to as a multi-chip package (MCP). Dies 2256 may include circuitry to perform any desired functionality. For example, besides one or more of dies 2256 being microelectronic assembly 100 as described herein, one or more of dies 2256 may be logic dies (e.g., silicon-based dies), one or more of dies 2256 may be memory dies (e.g., HBM), etc. In some embodiments, any of dies 2256 may be implemented as discussed with reference to any of the previous figures. In some embodiments, at least some of dies 2256 may not include implementations as described herein.

Although IC package 2200 illustrated in the figure is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package substrate 2252, or on either face of interposer 2257. More generally, IC package 2200 may include any other active or passive components known in the art.

In some embodiments, no interposer 2257 may be included in IC package 2200; instead, dies 2256 may be coupled directly to conductive contacts 2263 at first face 2272 by first-level interconnects 2265.

FIG. 10 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 9.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package substrate.

As illustrated in the figure, in some embodiments, IC device assembly 2300 may include a package-on-interposer structure 2336 coupled to first face 2340 of circuit board 2302 by coupling components 2316. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. Coupling components 2318 may take any suitable form depending on desired functionalities, such as the forms discussed above with reference to coupling components 2316. In some embodiments, IC package 2320 may be or include IC package 2200, e.g., as described above with reference to FIG. 9. In some embodiments, IC package 2320 may include at least one microelectronic assembly 100 as described herein. Microelectronic assembly 100 is not specifically shown in the figure in order to not clutter the drawing.

Although a single IC package 2320 is shown in the figure, multiple IC packages may be coupled to interposer 2304; indeed, additional interposers may be coupled to interposer 2304. Interposer 2304 may provide an intervening package substrate used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in the figure, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass-reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including but not limited to TSVs 2306. Interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 11 is a block diagram of an example computing device 2400 that may include one or more components having one or more IC packages in accordance with any of the embodiments disclosed herein. For example, any suitable ones of the components of computing device 2400 may include a microelectronic assembly (e.g., 100) in accordance with any of the embodiments disclosed herein. In another example, any one or more of the components of computing device 2400 may include any embodiments of IC package 2200 (e.g., as shown in FIG. 9). In yet another example, any one or more of the components of computing device 2400 may include an IC device assembly 2300 (e.g., as shown in FIG. 10).

A number of components are illustrated in the figure as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SoC die.

Additionally, in various embodiments, computing device 2400 may not include one or more of the components illustrated in the figure, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more DSPs, ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid-state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), LTE project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

Example 1 provides a microelectronic assembly, including a first die having a surface; a second die and a third die, the second die and the third die having a first surface and an opposing second surface, where the first surfaces of the second die and the third die are electrically coupled to the surface of the first die; a first material on the surface of the first die and around and between the second die and the third die, the first material having a non-planar surface; and a layer on and in physical contact with the non-planar surface of the first material and with the second surfaces of the second die and the third die, the layer including a second material having a thermal conductivity equal to or greater than 10 watt per meter-kelvin (W/m-K).

Example 2 provides the microelectronic assembly of example 1, where the first material includes silicon and nitrogen, silicon and oxygen, or silicon, nitrogen, and carbon; a polymer material; a mold material; or a low-k or ultra low-k dielectric.

Example 3 provides the microelectronic assembly of example 1 or 2, where the second material includes one or more of copper, aluminum, aluminum and nitrogen, diamond, silicon and carbon, boron and nitrogen, and boron and arsenic.

Example 4 provides the microelectronic assembly of any one of examples 1-3, where a thickness of the second material on the second surfaces of the second die and the third die is between 1 micron and 2 microns.

Example 5 provides the microelectronic assembly of any one of examples 1-4, where the layer further includes a third material between the second material and the non-planar surface of the first material and the second surfaces of the second die and the third die, the third material including one or more of titanium, titanium and nitrogen, tantalum, tantalum and nitrogen, ruthenium, and tungsten.

Example 6 provides the microelectronic assembly of example 5, where the third material has a thickness between 1 nanometer and 50 nanometers.

Example 7 provides the microelectronic assembly of any one of examples 1-6, further including a substrate coupled to the layer.

Example 8 provides the microelectronic assembly of example 7, where a material of the substrate includes silicon.

Example 9 provides the microelectronic assembly of example 7 or 8, further including a fourth material between the layer and the substrate, where the fourth material includes one or more of titanium, tantalum, gold, ruthenium, silver, aluminum and nitrogen, silicon and oxygen, silicon and nitrogen, and silicon, carbon, and nitrogen.

Example 10 provides the microelectronic assembly of example 9, where the fourth material has a thickness between 0.2 nanometers and 100 nanometers.

Example 11 provides the microelectronic assembly of example 9 or 10, further including a fifth material between the substrate and the fourth material, the fifth material including titanium, titanium and nitrogen, tantalum, tantalum and nitrogen, ruthenium, or tungsten.

Example 12 provides the microelectronic assembly of example 11, where the fifth material has a thickness between 1 nanometer and 50 nanometers.

Example 13 provides the microelectronic assembly of any one of examples 1-12, further including a via through the first material, the via including a conductive material and conductively coupled to the first die and the second material.

Example 14 provides the microelectronic assembly of example 13, where the via is one of a plurality of vias.

Example 15 provides the microelectronic assembly of any one of examples 1-14, where the surface of the first die is a second surface, and the first die further includes a first surface opposite the second surface, and the microelectronic assembly further including a package substrate electrically coupled to the first surface of the first die by solder interconnects.

Example 16 provides a microelectronic assembly, including a first die having a surface; second dies having a first surface and an opposing second surface, the first surfaces of the second dies electrically coupled to the surface of the first die; a first material, on the surface of the first die, around and between the second dies, the first material having a non-planar surface and including silicon and nitrogen, silicon and oxygen, or silicon, nitrogen, and carbon; a second material on the non-planar surface of the first material and the second surfaces of the second dies, the second material including titanium, titanium and nitrogen, tantalum, tantalum and nitrogen, ruthenium, or tungsten; a third material on the second material, the third material including one or more of copper, aluminum, aluminum and nitrogen, diamond, silicon and carbon, boron and nitrogen, and boron and arsenic; a fourth material on the third material, the fourth material including one or more of titanium, tantalum, gold, ruthenium, silver, aluminum and nitrogen, silicon and oxygen, silicon and nitrogen, and silicon, carbon, and nitrogen; and a substrate on the fourth material, where a material of the substrate includes silicon.

Example 17 provides the microelectronic assembly of example 16, where the second material has a thickness between 1 nanometer and 50 nanometers.

Example 18 provides the microelectronic assembly of example 16 or 17, where a thickness of the third material on the second surfaces of the second dies is between 1 micron and 2 microns.

Example 19 provides the microelectronic assembly of any one of examples 16-18, where the fourth material has a thickness between 0.5 nanometers and 100 nanometers.

Example 20 provides the microelectronic assembly of any one of examples 16-19, further including a fifth material between the substrate and the fourth material, the fifth material including titanium, titanium and nitrogen, tantalum, tantalum and nitrogen, ruthenium, or tungsten.

Example 21 provides the microelectronic assembly of example 20, where the fifth material has a thickness between 1 nanometer and 50 nanometers.

Example 22 provides a microelectronic assembly, including a first layer including a first die; a second layer, on the first layer, including two or more second dies and a dielectric material around and between the two or more second dies, where the first die is electrically coupled to the two or more second dies by interconnects having a pitch of less than 10 microns between adjacent interconnects, and where a surface of the dielectric material has an inconsistent topography; a third layer, on the second layer, including a high thermal conductivity material on the two or more second dies and on at least a portion of the dielectric material between the two or more second dies, and where a thickness of the high thermal conductivity material on the two or more second dies is between 1 micron and 2 microns; and a substrate on the third layer.

Example 23 provides the microelectronic assembly of example 22, where the dielectric material includes silicon and nitrogen, silicon and oxygen, or silicon, nitrogen, and carbon; a polymer material; a mold material; or a low-k or ultra low-k dielectric.

Example 24 provides the microelectronic assembly of example 22 or 23, where the high thermal conductivity material includes one or more of copper, aluminum, aluminum and nitrogen, diamond, silicon and carbon, boron and nitrogen, and boron and arsenic.

Example 25 provides the microelectronic assembly of any one of examples 22-24, where a material of the substrate includes silicon.

Example 26 provides the microelectronic assembly of any one of examples 22-25, where the third layer further includes a liner between the second layer and the high thermal conductivity material, where a material of the liner includes titanium, titanium and nitrogen, tantalum, tantalum and nitrogen, ruthenium, or tungsten.

Example 27 provides the microelectronic assembly of example 26, where the liner has a thickness between 1 nanometer and 50 nanometers.

Example 28 provides the microelectronic assembly of any one of examples 22-27, where the substrate is coupled to the third layer by a bonding material, the bonding material including one or more of titanium, tantalum, gold, ruthenium, silver, aluminum and nitrogen, silicon and oxygen, silicon and nitrogen, and silicon, carbon, and nitrogen.

Example 29 provides the microelectronic assembly of example 28, where the bonding material has a thickness between 0.2 nanometers and 100 nanometers.

Example 30 provides the microelectronic assembly of example 28 or 29, further including a liner between the substrate and the bonding material, where a material of the liner includes titanium, titanium and nitrogen, tantalum, tantalum and nitrogen, ruthenium, or tungsten.

Example 31 provides the microelectronic assembly of example 30, where the liner has a thickness between 1 nanometer and 50 nanometers.

Example 32 provides the microelectronic assembly of any one of examples 22-31, where the first die is one of a plurality of first dies, and where individual ones of the two or more second dies are electrically coupled to individual ones of the plurality of first dies.

Example 33 provides the microelectronic assembly of any one of examples 22-32, further including a package substrate electrically coupled to the first layer, at a surface opposite the second layer, by solder interconnects.

## Claims

1. A microelectronic assembly, comprising:
a first die having a surface;
a second die and a third die, the second die and the third die having a first surface and an opposing second surface, wherein the first surfaces of the second die and the third die are electrically coupled to the surface of the first die;
a first material on the surface of the first die and around and between the second die and the third die, the first material having a non-planar surface; and
a layer on and in physical contact with the non-planar surface of the first material and with the second surfaces of the second die and the third die, the layer including a second material having a thermal conductivity equal to or greater than 10 watt per meter-kelvin (W/m-K).

2. The microelectronic assembly of claim 1, wherein the first material includes silicon and nitrogen, silicon and oxygen, or silicon, nitrogen, and carbon; a polymer material; a mold material; or a low-k or ultra low-k dielectric.

3. The microelectronic assembly of claim 1 or 2, wherein the second material includes one or more of copper, aluminum, aluminum and nitrogen, diamond, silicon and carbon, boron and nitrogen, and boron and arsenic.

4. The microelectronic assembly of any one of claims 1-3, wherein a thickness of the second material on the second surfaces of the second die and the third die is between 1 micron and 2 microns.

5. The microelectronic assembly of any one of claims 1-4, wherein the layer further comprises:
a third material between the second material and the non-planar surface of the first material and the second surfaces of the second die and the third die, the third material including one or more of titanium, titanium and nitrogen, tantalum, tantalum and nitrogen, ruthenium, and tungsten.

6. The microelectronic assembly of claim 5, wherein the third material has a thickness between 1 nanometer and 50 nanometers.

7. The microelectronic assembly of any one of claims 1-6, further comprising:
a substrate coupled to the layer.

8. The microelectronic assembly of claim 7, wherein a material of the substrate includes silicon.

9. The microelectronic assembly of claim 7, further comprising:
a fourth material between the layer and the substrate, wherein the fourth material includes one or
more of titanium, tantalum, gold, ruthenium, silver, aluminum and nitrogen, silicon and oxygen, silicon and nitrogen, and silicon, carbon, and nitrogen.

10. The microelectronic assembly of claim 9, wherein the fourth material has a thickness between 0.2 nanometers and 100 nanometers.

11. The microelectronic assembly of any one of claims 1-10, further comprising:
a via through the first material, the via including a conductive material and conductively coupled to the first die and the second material.

12. An integrated circuit (IC) package, comprising:
a first layer including a first die;
a second layer, on the first layer, including two or more second dies and a dielectric material around and between the two or more second dies, wherein the first die is electrically coupled to the two or more second dies by interconnects having a pitch of less than 10 microns between adjacent interconnects,
and wherein a surface of the dielectric material has an inconsistent topography;
a third layer, on the second layer, including a high thermal conductivity material on the two or more second dies and on at least a portion of the dielectric material between the two or more second dies,
and wherein a thickness of the high thermal conductivity material on the two or more second dies is between 1 micron and 2 microns; and
a substrate on the third layer.

13. The IC package of claim 12, wherein the high thermal conductivity material includes one or more of copper, aluminum, aluminum and nitrogen, diamond, silicon and carbon, boron and nitrogen, and boron and arsenic.

14. The IC package of claim 12 or 13, wherein the substrate is coupled to the third layer by a bonding material, the bonding material including one or more of titanium, tantalum, gold, ruthenium, silver, aluminum and nitrogen, silicon and oxygen, silicon and nitrogen, and silicon, carbon, and nitrogen.

15. The IC package of any one of claims 12-14, wherein the first die is one of a plurality of first dies, and wherein individual ones of the two or more second dies are electrically coupled to individual ones of the plurality of first dies.
